(19) Europäisches Patentamt
European Patent Office
Office européen des brevets

(11) EP 3 557 493 A1

(12) **EUROPEAN PATENT APPLICATION**
published in accordance with Art. 153(4) EPC

(43) Date of publication:
**23.10.2019 Bulletin 2019/43**

(21) Application number: **17882203.7**

(22) Date of filing: **30.11.2017**

(51) Int Cl.:
***G06N 99/00*** *(2019.01)*

(86) International application number:
**PCT/JP2017/043163**

(87) International publication number:
**WO 2018/110305 (21.06.2018 Gazette 2018/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **14.12.2016 JP 2016241920**

(71) Applicant: **Sony Corporation**
**Tokyo 108-0075 (JP)**

(72) Inventors:
- **SUZUKI Hirotaka**
**Tokyo 108-0075 (JP)**
- **NARIHIRA Takuya**
**Tokyo 108-0075 (JP)**
- **OSATO Akihito**
**Tokyo 108-0075 (JP)**
- **NAKADA Kento**
**Tokyo 108-0075 (JP)**

(74) Representative: **MFG Patentanwälte**
**Meyer-Wildhagen Meggle-Freund**
**Gerhard PartG mbB**
**Amalienstraße 62**
**80799 München (DE)**

# (54) INFORMATION PROCESSING DEVICE AND INFORMATION PROCESSING METHOD

(57) The present technique relates to an information processing apparatus and an information processing method allowing variations of scenes of various events to be realized in a simulator environment simulating the real world.

A reward providing unit provides rewards to a first agent and a second agent taking action in the simulator environment and learning an action decision rule according to the reward for the action. The first agent is provided with the reward in accordance with a prescribed reward definition. Furthermore, the second agent is provided with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent. The present technique is applicable, for example, to reinforcement learning of the agents.

FIG.2

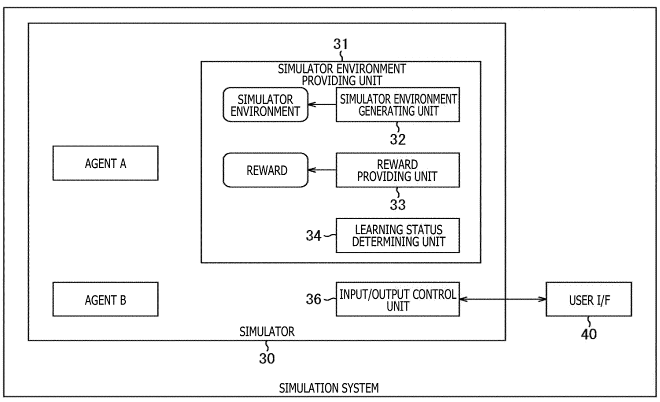


EP 3 557 493 A1

## Description

[Technical Field]

The present technique relates to an information processing apparatus and an information processing method, and in particular, to an information processing apparatus and an information processing method allowing variations of scenes of various events to be realized, for example, in a simulator environment simulating a real world.

[Background Art]

In a simulator environment simulating a real world, learning referred to as reinforcement learning is included in a framework of machine learning in which an (artificial intelligence) agent acting in the simulator environment learns an action decision rule to take a desired action according to a purpose and a situation.

In the reinforcement learning, the agent decides an action a in accordance with a learning model used as the action decision rule, on the basis of a state s including observable observed values as components. The agent takes the action a in accordance with the learning model and receives, for the action a, a reward r representing whether the action a is suitable for achieving a desired purpose. The agent then uses the action a, the state s after taking of the action a, and the reward r for the action a to update the learning model so as to increase the (sum of) reward(s) r to be received in the future. The agent decides the action a in accordance with the updated learning model and subsequently repeats a similar process.

The learning model used for the reinforcement learning is, for example, Deep Q Net (Network) (see, for example, NPL 1).

In the reinforcement learning, the reward r is calculated in accordance with a predetermined reward definition. The reward definition is a guideline for calculation of the reward, and is, for example, an equation such as a function which allows the state s after the agent's taking of the action a to be checked against a state expected for the agent by a human being to quantitatively expressing whether the state s after the agent's taking of the action a is good or bad.

In the reinforcement learning, a searching action is mixed into the action of the agent. In particular, in an initial period of learning, a learning model used as the action decision rule is learned through random actions. During a process in which the agent takes the searching action, when real hardware is used in the real world, a heavy burden is imposed on the environment of the real world and on the hardware. That is, in the worst case, an object in the real world and the hardware may collide against each other and be damaged.

Thus, a simulator environment simulating the real world is generated, and the reinforcement learning of the agent is implemented by executing simulation in which a (virtual) agent is caused to act in the simulator environment.

After the learning of the agent in the simulator environment, the (learning model of) agent is applied to an actual apparatus or the like to allow the apparatus or the like to take appropriate actions (perform appropriate operations) in the real world.

[Citation List]

[Non Patent Literature]

[NPL 1]
Mnih, Volodymyr, et al. "Human-level control through deep reinforcement learning.", Nature 518.7540(2015): 529-533.

[Summary]

[Technical Problem]

In a case where, in the simulator environment, an agent A intended for learning is coexistent with an agent B not intended for learning, the agent B is, for example, programmed to act in accordance with a predetermined rule.

In this case, the agent B is allowed to take only preliminarily assumed actions. As a result, variations of scenes reproducible in the simulator environment are limited.

On the other hand, for learning of the agent A intended for learning, the capability of generating actions appropriate to exceptional events that rarely occur in the real world is often very important.

For example, in a case where the agent A is an agent used as a self-driving vehicle learning a vehicle control rule and the agent B is an agent used as another vehicle such as a bicycle, a pedestrian, or the like, the action of the agent B used as the bicycle, pedestrian, or the like is preprogrammed, for example, in accordance with a realistic, standard physical model or action model.

However, in a case where the action of the agent B is programmed, it is difficult to reproduce, in the simulator environment, variations of scenes of various events that may occur exceptionally, such as an event where the pedestrian runs into a street and an event where a vehicle travels a wrong way.

In view of these circumstances, an object of the present technique is to allow variations of scenes of various events to be realized in a simulator environment simulating the real world.

[Solution to Problem]

An information processing apparatus of the present technique includes a simulator environment generating unit generating a simulator environment simulating a real world, and a reward providing unit for a first agent and a second agent taking action in the simulator environment and learning an action decision rule according to a reward for the action, the reward providing unit providing the first agent with the reward in accordance with a prescribed reward definition and providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

An information processing method of the present technique includes generating a simulator environment simulating a real world, and for a first agent and a second agent taking action in the simulator environment and learning an action decision rule according to a reward for the action, providing the first agent with the reward in accordance with a prescribed reward definition and providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

In the information processing apparatus and information processing method of the present technique, the reward is provided to the first agent and the second agent taking action in the simulator environment simulating the real world and learning the action decision rule according to the reward for the action. The first agent is provided with the reward in accordance with the prescribed reward definition. Furthermore, the second agent is provided with reward in accordance with the opposing reward definition opposing the prescribed reward definition, the opposing reward definition causing a resultant reward to be increased in the case where the second agent acts to bring about the situation where the reward for the first agent is reduced and causing a resultant reward to be reduced in the case where the second agent acts to increase the reward for the first agent.

The information processing apparatus may be an independent apparatus or an internal block included in one apparatus.

Furthermore, the information processing apparatus can be implemented by causing a computer to execute a program. Such a program can be provided by being transmitted via a transmission medium or being recorded in a recording medium.

[Advantageous Effect of Invention]

In the present techniques, in the simulator environment simulating the real world, variations of scenes of various events can be realized.

The effect described here is not necessarily limited but may be any one of the effects described in the present disclosure.

[Brief Description of Drawings]

FIG. 1 is a diagram illustrating an outline of reinforcement learning.

FIG. 2 is a block diagram illustrating an example of a functional configuration of an embodiment of a simulation system to which the present technique is applied.

FIG. 3 is a block diagram illustrating an example of a functional configuration of an agent A.

FIG. 4 is a plan view schematically illustrating an example of a simulator environment generated by a simulator environment generating unit 32.

FIG. 5 is a diagram illustrating examples of components of a state s of the agent A.

FIG. 6 is a diagram illustrating an example of an action a of the agent A.

FIG. 7 is a diagram illustrating an example of learning of a learning unit 65 of the agent A and an action decision by an action deciding unit 66.

FIG. 8 is a diagram illustrating an example of a reward definition for the agent A.

FIG. 9 is a diagram illustrating an example of the agent B.

FIG. 10 is a flowchart illustrating an example of a process of the agent A.

FIG. 11 is a flowchart illustrating an example of a process of a simulator environment providing unit 31.

FIG. 12 is a diagram schematically illustrating examples of change patterns of the reward for the agent A or B.

FIG. 13 is a diagram illustrating an example of display of a GUI displayed on a user I/F 40.

FIG. 14 is a flowchart illustrating an example of an alert issuing process for issuing an alert.

FIG. 15 is a flowchart illustrating an example of an alert issuing process for issuing an alert.

FIG. 16 is a block diagram illustrating an example of a configuration of an embodiment of a computer to which the present technique is applied.

[Description of Embodiments]

<Outline of Reinforcement Learning>

FIG. 1 is a diagram illustrating an outline of reinforcement learning.

An agent 10 intended for learning is a virtual agent and includes an experiment DB (Database) 11, a learning unit 12, and an action deciding unit 13.

The agent 10 is placed in a simulator environment simulating a real world.

In the agent 10, the action deciding unit 13 decides an action a in accordance with a learning model used as an action decision rule $\pi^*(a|s)$ on the basis of a state s including, as components, observed values observable by the agent 10. The agent 10 takes, in the simulator environment, the action (hereinafter also referred to as the decided action) a decided by the action deciding unit 13.

The action decision rule $\pi^*(a|s)$ is, for example, a probability distribution of the action a for various states, and an action a with the highest probability for the state s is decided as an action (decided action) to be taken by the agent 10.

The agent 10 receives from the simulator environment, for the action a, a reward r representing whether the decided action a is suitable for achieving a desired purpose.

Moreover, in the agent 10, the learning unit 12 uses the (decided) action a, the state s after taking of the action a, and the reward r for the action a to cause the agent 10 to learn the action decision rule $\pi^*(a|s)$ (a learning model used as the action decision rule $\pi^*(a|s)$ so as to increase the (sum of) reward(s) r to be received in the future.

In the agent 10, the action deciding unit 13 decides the next action a in accordance with the learned action decision rule $\pi^*(a|s)$ on the basis of the state s after taking of the action a. A similar process is subsequently repeated.

The state s, the action a, and the reward r at a point in time t are respectively represented as a state $s_t$, an action at, and a reward $r_t$, and the experiment DB 11 stores a time series of the state s, the action a, and the reward r $(s_1, a_1, r_1, s_2, a_2, r_2, \cdots s_N, a_N, r_N, \cdots)$.

The learning unit 12 uses the time series of the state s, the action a, and the reward r stored in the experiment DB 11 to learn an action decision rule $\pi^*(a|s)$ maximizing an expected reward and defined by Equation (1).

$$\pi^*(a|s) = \mathrm{argmax}_\pi E[\Sigma\gamma^t R(s_t, a_t, s_{t+1})|s_1 = s(1), a_1 = a(1)] \quad \cdot\cdot\ (1)$$

In Equation (1), $\mathrm{argmax}_\pi[x]$ represents one of action decision rules $\pi$ that maximizes x, and E[x] represents an expected value of x. $\Sigma$ represents summation with t varied from an initial value of 1 to $\infty$. $\gamma$ is a parameter referred to as a discount rate for which a value of more than or equal to 0 and less than 1 is adopted. $R(s_t, a_t, s_{t+1})$ represents, in the state s, a scalar value corresponding to the reward r obtained when the state $s_{t+1}$ results from the taking of the action at by the agent 10. s(1) represents the (initial value of) state at a point in time t = 1, and a(1) represents the (initial value of) action at the point in time t = 1.

In Equation (1), $E[\Sigma\gamma^t R(s_t, a_t, s_{t+1})|s_1 = s(1), a_1 = a(1)]$ represents an expected reward, that is, an expected value of the sum $\Sigma\gamma^t R(s_t, a_t, s_{t+1})$ of the rewards r to be obtained in the future.

Consequently, according to Equation (1), $\pi^*(a|s)$ is one of the action decision rules $\pi$ that maximizes the expected reward $E[\Sigma\gamma^t R(s_t, a_t, s_{t+1})|s_1 = s(1), a_1 = a(1)]$.

<Embodiment of Simulation System to which Present Technique is Applied>

FIG. 2 is a block diagram illustrating an example of a functional configuration of an embodiment of a simulation system to which the present technique is applied.

In FIG. 2, the simulation system includes a simulator 30 and a user I/F (Interface) 40.

The simulator 30 includes a (virtual) agent A intended for learning (first agent) and a (virtual) agent B (second agent) not intended for learning.

In FIG. 2, only one agent A is intended for learning. However, a plurality of agents may be intended for learning. This also applies to the agent not intended for learning. That is, the simulator 30 may be provided with one or more agents intended for learning and one or more agents not intended for learning.

The simulator 30 includes, besides the agents A and B, a simulator environment providing unit 31 and an input/output control unit 36.

The simulator environment providing unit 31 includes a simulator environment generating unit 32, a reward providing unit 33, and a learning status determining unit 34 to execute various processes related to provision of the simulator environment.

The simulator environment generating unit 32 generates and provides the simulator environment. The agents A and B act in the simulator environment provided by the simulator environment generating unit 32 and learn the action decision rule through reinforcement learning.

The reward providing unit 33 observes the agents A and B and the simulator environment, and based on results of the observation, calculates and provides the rewards r for the (actions a of) agents A and B.

The reward providing unit 33 calculates the reward r for the agent A in accordance with a prescribed reward definition, and calculates the reward r for the agent B in accordance with an opposing reward definition opposing the reward definition for the agent A.

The opposing reward definition opposing the reward definition for the agent A means a reward definition causing a resultant reward to be increased in a case where the agent B acts to bring about a situation where the reward for the agent A is reduced and causing a resultant reward to be reduced in a case where the agent B acts to increase the reward for the agent A.

The reduced reward includes, besides a reward with a small, positive value, a reward with a zero or negative value.

The learning status determining unit 34 determines learning statuses of learning (of the action decision rule $\pi^*(a|s)$) by the agents A and B, for example, according to change patterns of the rewards for the agents A and B calculated by the reward providing unit 33.

The input/output control unit 36 controls input and output of information to and from the user I/F 40.

The user I/F 40 includes devices such as a touch panel, a display, a speaker, a keyboard, a pointing device, and a communication I/F which transmit and receive information to and from a user.

The input/output control unit 36 functions as a display control unit causing the touch panel and the display included in the user I/F 40 to display an image such as a GUI (Graphical User Interface) and any other information.

Furthermore, the input/output control unit 36 functions as an output control unit causing a speaker included in the user I/F 40 to output sound and any other acoustic information.

The input/output control unit 36 further functions as an accepting unit accepting inputs of operations, by the user, of the touch panel, the keyboard, and the pointing device, used as the user I/F 40, the operable GUI, and the like.

The input/output control unit 36 also functions as an issuance control unit causing the user I/F 40 to issue an alert according to the learning status of the agent A or B. That is, the input/output control unit 36 causes the touch panel, the display, and the speaker, included in the user I/F 40, to output (display) a message used as an alert. The input/output control unit 36 also, for example, causes the communication I/F, included in the user I/F 40, to transmit a mail or any other message used as an alert.

<Example of Configuration of Agents A and B>

FIG. 3 is a block diagram illustrating an example of a functional configuration of the agent A in FIG. 2.

The agent B can also be configured similarly to the agent A in FIG. 3.

The agent A includes an action planning unit 61, a surrounding-environment information acquiring unit 62, a data acquiring unit 63, a database 64, a learning unit 65, an action deciding unit 66, and an action control unit 67.

The action planning unit 61 executes, as action planning, for example, setting of a target route for the agent A. The action planning unit 61 further sets points (hereinafter also referred to as waypoints), for example, at regular intervals on the target route for the agent A.

The surrounding-environment information acquiring unit 62 acquires information regarding a surrounding environment of the agent A in the simulator environment (hereinafter also referred to as surrounding-environment information).

That is, the surrounding-environment information acquiring unit 62 acquires, as surrounding-environment information, distance information obtained by a distance sensor such as LiDAR by sensing a distance to a certain object present around the agent A in the simulator environment (distance information that could be obtained by sensing of the distance sensor in the real world).

The data acquiring unit 63 acquires an observed value observable by the agent A to determine, as the state s, a vector including the observed value as a component. For example, the data acquiring unit 63 acquires the (coordinates of) waypoints set by the action planning unit 61, the distance information acquired as the surrounding-environment information by the surrounding-environment information acquiring unit 62, and the like and determines, as the state s, a vector including the waypoints, the distance information, and the like as components.

The data acquiring unit 63 also acquires the action a determined by the action deciding unit 66 and the reward r provided by the reward providing unit 33 (FIG. 2).

The data acquiring unit 63 feeds states s, actions a, and rewards r to the database 64 in a chronological order.

The database 64 stores the time series of the states s, the actions a, and the rewards r fed from the data acquiring unit 63.

The learning unit 65 uses, as necessary, the states s, the actions a, and the rewards r stored in the database 64 to learn (update) a learning model used as the action decision rule $\pi^*(a|s)$. For example, Deep Q Net can be adopted as the learning model.

The action deciding unit 66 decides the action a in accordance with Deep Q Net having learned by the learning unit 65, on the basis of the latest state s stored in the database 64. The action deciding unit 66 then feeds the (information regarding) action a to the action control unit 67.

The action control unit 67 controls the agent A to cause the agent A to take the (decided) action a provided by the action deciding unit 66.

<Example of Simulation Environment>

FIG. 4 is a plan view schematically illustrating an example of a simulator environment generated by the simulator environment generating unit 32 (FIG. 2).

The simulator environment in FIG. 4 is an environment simulating a certain road traffic environment in the real world.

In the description below, as the agent A, an agent of a car (self-driving vehicle) is used that is allowed to take autonomous actions through learning. As the agent B, an agent of a human being or a bicycle is used that is coexistent with the car in the real world. The following description is based on the assumption that such agents A and B are placed in the simulator environment.

<Example of Components of State s of Agent A>

FIG. 5 is a diagram illustrating examples of components of the state s of the agent A.

As a component of the state s of the agent A, the distance information can be adopted that is obtained by the distance sensor such as LiDAR by sensing the distance to a certain object present around the agent A in the simulator environment (distance information that could be obtained by sensing of the distance sensor in the real world).

The distance information can be obtained in a plurality of directions around the agent A. As a component of the state s of the agent A, a direction in which the distance information is obtained can be adopted (direction in the distance information).

Furthermore, as a component of the state s of the agent A, relative coordinates ($\Delta x$, $\Delta y$) of a plurality of waypoints located close to the agent A on the target route, with the position of the agent A used as a reference for the relative coordinates, can be adopted.

Moreover, as a component of the state s of the agent A, a speed of the agent A can be adopted.

As the state s of the agent A, a vector with a plurality of dimensions such as 810 dimensions can be adopted, the vector including, as components, the distance information regarding directions in a plurality of frames, the directions in the distance information, the relative coordinates ($\Delta x$, $\Delta y$) of a plurality of waypoints, and the speed of the agent A.

<Example of Action of Agent A>

FIG. 6 is a diagram illustrating an example of the action a of the agent A.

The action a of the agent A, corresponding to a car agent (agent simulating a car), is intended for, for example, as illustrated at A in FIG. 6, a steering wheel, an accelerator pedal, a brake pedal, and the like which are operated when the car is steered.

Here, for easier description, the steering wheel and the accelerator pedal are adopted as targets of the action a of the agent A. Moreover, as the action a of the agent a, moving the steering wheel at a prescribed angular acceleration and moving the accelerator pedal at a prescribed acceleration are adopted. Furthermore, for the angular acceleration of the steering wheel, three angular accelerations of $-\alpha$, 0, and $+\alpha$ are adopted; the positive value is indicative of a clockwise direction. For the acceleration of the accelerator pedal, $-\alpha$, 0, and $+\beta$ are adopted; the positive value is indicative of a direction in which the accelerator pedal is stepped on.

In this case, the action a of the agent A includes nine types of combinations of actions corresponding to three angular accelerations of the steering wheel, $-\alpha$, 0, and $+\alpha$, with the three accelerations of the accelerator pedal, $-\beta$, 0, and $+\beta$.

The nine types of the action a are represented by the symbol a = 1, 2, ···, 9.

<Example of Learning of Agent A and Action Decision>

FIG. 7 is a diagram illustrating an example of learning in the learning unit 65 of the agent A and an example of action decision in the action deciding unit 66.

The learning unit 65 executes, for example, learning of the Deep Q Net (deep reinforcement learning) as learning of the action decision rule $\pi^*(a|s)$ maximizing the expected reward.

In the present embodiment, Deep Q Net uses, as the state s, a vector with a plurality of dimensions such as 810 dimensions which includes, as components, the distance information regarding the directions in a plurality of frames, the directions in the distance information, the relative coordinates ($\Delta x$, $\Delta y$) of a plurality of waypoints, and the speed of the agent A, and with respect to an input of the state s, outputs function values of value functions Q(s, 1), Q(s, 2), ···, Q(s, 9) for the action a with the nine symbols a = 1, 2, ···, 9, respectively.

In the learning in the learning unit 65, the value function Q(s, a) is updated according to the reward r obtained when the agent A takes a certain action a in a certain state s. For example, the value function Q(s, a) is updated such that the function value increases consistently with reward r.

The action deciding unit 66 decides the action a in accordance with the learned (updated) Deep Q Net on the basis of the state s.

That is, the action deciding unit 66 inputs the state s to the Deep Q Net, and decides the action $a = f(s) = \mathrm{argmax}_a Q(s, a)$ to be the decided action; the action $a = f(s) = \mathrm{argmax}_a Q(s, a)$ corresponds to a value function Q(s, a) with the largest of the function values of the value functions Q(s, 1), Q(s, 2), ···, Q(s, 9) for the actions with the nine symbols a = 1, 2, ···, 9, respectively, obtained from the input.

<Example of Reward Definition for Agent A>

FIG. 8 is a diagram illustrating an example of a reward definition for the agent A, that is, a reward definition used to calculate the reward r for the agent A.

The reward definition for the agent A can be represented using, as variables serving as indicators for safe driving, for example, a variable R1 representing "not collide," a variable R2 representing traveling at an "appropriate car speed along a route," and a variable R3 representing a "follow route" (not travel off the route).

As the variable R1, for example, 1 is adopted in a case where a collision occurs and 0 is adopted in a case where no collision occurs. As the variable R2, for example, the inner product of a speed vector v1 representing the speed of the agent A and a vector v2 connecting two waypoints nearest to the agent A is adopted. As the variable R3, for example, a distance between the agent A and one waypoint nearest to the agent A is adopted. The variables R1 to R3 can be measures on which calculation of the reward is based.

In this case, the reward definition for the agent A can be represented, for example, by Equation (2) using $\omega_1$, $\omega_2$, and $\omega_3$ as weights.

$$r = \omega_1 R1 + \omega_2 R2 + \omega_3 R3 \qquad \cdots (2)$$

As the weights $\omega_1$, $\omega_2$, and $\omega_3$, for example, $\omega_1 = -20000$, $\omega_2 = 300$, and $\omega_3 = -500$ can be adopted.

According to the reward definition in Equation (2), setting of the weights $\omega_1$, $\omega_2$, and $\omega_3$ allows adjustment of which of R1 to R3 is focused on in the reward setting.

For example, in a case where the weight $\omega_1$ is set to a negative, large value, a reward r with a negative, large value is calculated when the agent A collides, in the simulator environment, against a wall, a human being, or a vehicle other than the agent A. Furthermore, for example, in a case where the weight $\omega_2$ is set to a large value, a reward r with a positive, large value is calculated when the agent A travels at the appropriate car speed along the target route.

<Agent B>

FIG. 9 is a diagram illustrating an example of the agent B.

As the agent B, for example, a human being (pedestrian) agent can be adopted. The agent B is configured, for example, to learn to move to a target point provided as a target (action) and to be able to take an action of moving at a speed within a range determined according to a position vector from the current point to the target point.

Moreover, the agent B is, as illustrated in FIG. 9, assumed to be able to observe the speed vector v1 and the relative position (coordinates), with reference to the agent B, of the agent A located at a given distance from (located nearest to) the agent B.

Furthermore, for the agent B, the Deep Q Net is adopted as a learning model as for the agent A. As the state s of the agent B, a vector can be adopted that includes, as components, the relative position of the above-described agent A and the speed vector v1.

As described for FIG. 2, the reward providing unit 33 calculates the reward r for the agent B in accordance with the opposing reward definition opposing the reward definition for the agent A.

As the opposing reward definition opposing the reward definition for the agent A described for FIG. 8, a reward definition is adopted by which a positive reward is calculated for an action of the agent B running into a course of the agent A and colliding against the agent A.

Specifically, as the opposing reward definition, a reward definition can be adopted by which the calculated positive value increases with decreasing relative distance to a predicted position pp located N steps (points in time) ahead of the agent A with reference to the position of the agent B.

Furthermore, for example, as the opposing reward definition, a reward definition can be adopted by which a positive reward is calculated in a case where the reward for the agent A is negative and in a case where the agent A collides against the agent B.

Besides the above-described opposing reward definition, the reward definition for the agent B includes a reward definition that adopts, as an indicator related to the appropriate action of the agent B, for example, "convergence of an average moving speed to the vicinity of a given value (for example, an average walking speed of a human being in a real environment)" and by which a positive reward is calculated in a case where the indicator is achieved.

Variables of a numerical value representing the indicator of the reward for the agent B are represented as U1, U2, U3, ···, and the weights are represented as $V_1$, $V_2$, $V_3$, ···. As the reward definition for the agent B, for example, a reward definition by which the reward r is calculated in accordance with Equation (3) is adopted.

$$r = U1 \times V_1 + U2 \times V_2 + U3 \times V_3 + \cdots \qquad \cdots (3)$$

<Example of Processes of Agents A and B>

FIG. 10 is a flowchart illustrating an example of a process of the agent A in FIG. 3.

In step S11, the data acquiring unit 63 of the agent A acquires and stores the latest state s, the reward r, and the action a in the database 64. The process proceeds to step S12.

In step S12, the learning unit 65 uses the state s, the action a, and the reward r stored in the database 64 to execute learning of the Deep Q Net used as a learning model (update the Deep Q Net). The process proceeds to step S13.

In step S13, the action deciding unit 66 decides the action a in accordance with the Deep Q Net learned by the learning unit 65, on the basis of the latest state s stored in the database 64. The process proceeds to step S14.

In step S14, the action control unit 67 controls the agent A to cause the agent A to take the (decided) action a provided by the action deciding unit 66. The process returns from step S14 to step S11, and a similar process is repeated.

The agent B executes a process similar to the process of the agent A.

<Example of Process of Simulator Environment Providing Unit 31>

FIG. 11 is a flowchart illustrating an example of a process of the simulator environment providing unit 31 in FIG. 2.

In step S21, the simulator environment providing unit 32 generates a simulator environment. The process proceeds to step S22. The agents A and B, executing the process in FIG. 10, are placed in the simulator environment generated by the simulator environment generating unit 32.

In step S22, the reward providing unit 33 observes the agents A and B and the simulator environment, and on the basis of results of the observation, calculates the reward r for the (action a of) agent A in accordance with the reward definition for the agent A described for FIG. 8.

Moreover, the reward providing unit 33 calculates the reward r for the (action a of) agent B in accordance with the reward definition for the agent B described for FIG. 9, that is, the opposing reward definition opposing the reward definition for the agent A, on the basis of the results of the observation of the agents A and B and the simulator environment.

The reward providing unit 33 then provides the agent A with the reward r for the agent A, and provides the agent B with the reward r for the agent B. The process returns from step S23 to step S22, and a similar process is repeated.

As described above, the reward providing unit 33 provides the agent A with the reward based on the prescribed reward definition and provides the agent B with the reward based on the opposing reward definition opposing the reward definition for the agent A. Thus, the agent B acts to bring about the worst case or various exceptionally possible events (for example, running of a bicycle, a human being, or the like into the route). As a result, variations of scenes of various events can be realized in the simulator environment.

Moreover, the agent A, corresponding to an agent of a vehicle, executes learning in the simulator environment in which variation of scenes of various events are realized. This allows the agent A to acquire the action decision rule causing the agent A to take robust, appropriate actions for various events including exceptional events. The action decision rule is applied to vehicle control to allow self-driving to be achieved.

The following process is also possible. The agents A and B execute learning in the simulator environment generated by the simulator environment generating unit 32. Then, an agent C having learned self-driving in another simulator environment is introduced, along with the agent B having finished learning, into the simulator environment generated by the simulator environment generating unit 32. This allows quantitative measurement of the degree to which the agent C is applied to the environment, that is, for example, the appropriateness of learning of self-driving by the agent C.

<Change Patterns of Reward r>

FIG. 12 is a diagram schematically illustrating examples of change patterns of the reward for the agent A or B.

In FIG. 12, the abscissa axis indicates the number of steps (time), and the ordinate axis indicates the reward.

When the agents A and B execute learning in a simulator environment simulating a road traffic environment, the agent B initially takes random actions. However, as the learning progresses appropriately, the agent B gradually starts taking such an action as approaches and collides against the agent A.

On the other hand, the agent A also initially takes random actions (motions). However, as the learning progresses appropriately, the agent A gradually starts taking such an action as avoids colliding against a wall and the like along the target route and avoiding running of the agent B into the route.

The agent B receives the reward based on the opposing reward definition opposing the reward definition for the agent A and can thus bring about, in the simulator environment, exceptional events that rarely occur in the real world (for example, running of a human being, a bicycle, or the like into the route). The agent A can learn appropriate actions (for example, avoidance of a collision against the agent B) to take when encountering such exceptional events.

The actions taken by the agents A and B as a result of the learning change, for example, according to settings of learning conditions such as the values of the weights $\omega_i$ and $V_i$, which define Equation (2) and Equation (3), used as the reward definitions for the agents A and B.

The learning may fail depending on the settings of the learning conditions. Thus, for example, the learning conditions such as the values of the weights $\omega_i$ and $V_i$ are appropriately adjusted at appropriate timings during the learning, enabling the learning to progress appropriately. The adjustment of the learning conditions as described above is referred to as learning difficulty level adjustment. The learning executed with the learning conditions appropriately adjusted is referred to as curriculum learning.

In the curriculum learning, for example, the learning conditions are set, at the beginning of the learning, to execute learning of an action of achieving an easy goal, and as the learning progresses, to execute learning of an action of achieving a difficult goal.

Specifically, at the beginning of the learning, for example, adjustment can be made to fix, to 0, the weights $\omega_1$ and $\omega_2$, included in the weight $\omega_i$ in Equation (2), used as a learning condition. In a case where the learning progresses somewhat appropriately, adjustment can be made to fix, to 0, only the weight $\omega_1$, included in the weight $\omega_i$ in Equation (2), used as a learning condition. In a case where the learning further progresses appropriately, the fixation of the weight $\omega_1$ in Equation (2), used as a learning condition, can be cleared, and the learning can be executed with none of the weights $\omega$ 1 to $\omega$ 3 fixed.

The following are also possible: an adjustment gradually increasing the number of agents B, used as a learning condition, according to the progress of the learning, an adjustment gradually increasing the speed of the agent B, used as a learning condition, according to the progress of the learning, an adjustment gradually increasing the number of agents B with different speeds, used as a learning condition according to the progress of the learning, and the like.

The adjustment (setting) of the learning conditions can be executed according to operation of an operator of the simulation system in FIG. 2 to allow the learning to progress strategically.

For example, the (values of) weights $\omega_i$ and $V_i$, used as learning conditions, can be adjusted by the user by operating the user I/F 40 (FIG. 1).

That is, the input/output control unit 36 can cause the user I/F 40 to display a GUI for adjustment of the weights $\omega_i$ and $V_i$. Moreover, the input/output control unit 36 can accept operation, by the operator, of the GUI displayed on the user I/F 40. The reward providing unit 33 can adjust the weights $\omega_i$ and $V_i$, used as parameters for the reward, according to the operation of the GUI accepted by the input/output control unit 36.

During the period of the learning of the agents A and B, the learning status determining unit 34 (FIG. 2) can record a log of the rewards provided to the respective agents A and B.

In a case where a plurality of agents A are introduced, individual logs of the rewards provided to the respective agents A may be recorded, or the average value of the rewards provided to the respective agents A may be recorded. This also applies to the agent B.

The input/output control unit 36 can use the logs of the rewards to display, on the user I/F 40, a graph plotting the rewards provided to the agents A and B in a chronological order (hereinafter referred to as a reward graph).

The operator can visually check, for a learning status (the degree of progress of the learning and the like), the reward graph displayed on the user I/F 40, and, on the basis of the learning status, determine a timing to adjust the parameters for the reward (here, the weights $\omega_i$ and $V_i$).

In terms of usability, the operator continuing to visually check the reward graph for the learning status is a burden on the operator.

Thus, the learning status determining unit 34 can determine the learning status on the basis of the reward graph, and the input/output control unit 36 can control, according to the learning status, issuance of an alert prompting adjustment of the parameter for the reward.

The alert can be issued by, for example, displaying, in a popup window on the user I/F 40, a message prompting adjustment of the parameter for the reward, transmitting the message by mail, or acoustically outputting the message.

FIG. 12 illustrates an example of the reward graph of the reward for the agent A or B.

The reward graph in FIG. 12 illustrates a time series of the moving average value of the reward for the agent A or B.

In a case where the learning of the agent A or B progresses appropriately, the change pattern of the reward graph is a pattern p1 with a continued increase as illustrated at A in FIG. 12. Accordingly, in a case where the change pattern of the reward graph is the pattern p1, regarding the learning status, the learning can be determined to have a status indicating that the learning progresses steadily to appropriately improve the action of the agent A or B.

In a case where the learning of the agent A or B converges, the change pattern of the reward graph is a pattern p2 with a convergence for a given period of time or longer following an increase (a change width has been kept within a range between prescribed thresholds) as illustrated at B in FIG. 12. Accordingly, in a case where the change pattern of the reward graph is the pattern p2, regarding the learning status, the learning can be determined to have a status indicating that the learning has been successful under the current learning conditions (task difficulty level).

In a case where the learning of the agent A or B does not progress appropriately (the learning has failed), the change pattern of the reward graph is a pattern p3 with substantially no change for a given period of time or longer with respect to the reward obtained at the beginning of the learning (or after the adjustment of the parameter for the reward) as illustrated at C in FIG. 12. Accordingly, in a case where the change pattern of the reward graph is the pattern p3, regarding the learning status, the learning can be determined to have a status indicating that the learning has failed.

In a case where the learning of the agent A or B progresses appropriately, besides a continued increase as illustrated at A in FIG. 12, the reward graph may indicate, for example, an increase followed by a temporary decrease or substantially no change, followed by restart of an increase as illustrated at D in FIG. 12.

The change pattern of the reward graph at D in FIG. 12, indicating an increase followed by a temporary decrease or substantially no change, followed by restart of an increase, fails to match the pattern p1 with a continued increase at A in FIG. 12. However, the change pattern of the reward graph at D in FIG. 12 matches the pattern p1 in that the pattern appears in a case where the learning progresses appropriately and that the pattern finally indicates an increase. The change pattern of the reward graph at D in FIG. 12 is thus classified as the pattern p1.

The learning status determining unit 34 determines the change pattern of the reward graph and thus the learning status to output a determination result for the change pattern of the reward graph as a determination result for the learning status.

The input/output control unit 36 causes the user I/F 40 to issue the alert prompting adjustment of the parameter for the reward according to the (determination result for) the change pattern of the reward graph provided as the determination result for the learning status by the learning status determining unit 34.

For example, in a case where the learning status determining unit 34 determines the change pattern of the reward graph to be the pattern p1 at A or D in FIG. 12, the learning has progressed steadily, and thus the input/output control unit 36 refrains from causing the issuance of the alert. Moreover, the simulator environment providing unit 31 causes the agents A and B to continue the learning without any change.

Furthermore, for example, in a case where the learning status determining unit 34 determines the change pattern of the reward graph to be the pattern p2 at B in FIG. 12, the learning has succeeded under the current learning conditions and converged. Thus, the input/output control unit 36 issues an alert by causing the user I/F 40 to display a message indicating the success and the convergence, "Learning has converged. Resetting of weight parameters is required." Moreover, the simulator environment providing unit 31 causes the agents A and B to suspend the learning.

The operator receives the message used as an alert, "Learning has converged. Resetting of weight parameters is required," and operates the GUI to adjust the parameters for the reward and reset the other learning conditions. The operator further operates the GUI to instruct restart of the learning to allow the agents A and B to restart the learning.

Alternatively, the operator receives the message used as an alert, "Learning has converged. Resetting of weight parameters is required," and determines that the agent A and B have executed sufficient learning. The operator thus operates the GUI to allow learning of the agent A and B to be ended.

Furthermore, for example, in a case where the learning status determining unit 34 determines that the change pattern of the reward graph to be the pattern p3 at C in FIG. 12, the learning under the current learning conditions has failed, and the input/output control unit 36 issues an alert by causing the user I/F 40 to display a message indicating the failure, "Learning has failed. Resetting of weight parameters is required." Moreover, the simulator environment providing unit 31 causes the agents A and B to suspend the learning.

The operator receives the message used as an alert, "Learning has failed. Resetting of weight parameters is required," and operates the GUI to adjust the parameter for the reward and reset the other learning conditions. The operator further operates the GUI to instruct restart of the learning to allow the agents A and B to restart the learning.

In a case of a failure in learning, when the learning is restarted with learning results for the period of the failed learning (hereinafter also referred to as failure results) taken over, the failure results may affect the learning following the restart. Thus, in a case of a failure in learning, the agents A and B can take over the latest learning results obtained at the time of convergence of the learning (take over predetermined initial values or the like in a case where the learning has not converged) and restart the learning. Past learning results for the agents A and B can be managed and stored by the agents A and B or by the simulator environment providing unit 31.

<Display Example of GUI>

FIG. 13 is a diagram illustrating a display example of the GUI displayed on the user I/F 40.

In FIG. 13, an simulator environment, sliders 81 and 82, and a message used as an alert (hereinafter also referred to as an alert message) are displayed as the GUI.

The slider 81 is operated to adjust the weight $\omega_i$, used as a parameter for the reward for the agent A. The slider 82 is operated to adjust the weight $V_i$, used as a parameter for the reward for the agent B.

A in FIG. 13 illustrates a display example of the GUI displayed in a case where the change pattern of the reward graph of the agent A is the pattern p3 at C in FIG. 12.

In the case where the change pattern of the reward graph of the agent A is the pattern p3, the learning of the agent A under the current learning conditions has failed. Thus, an alert message at A in FIG. 13 is "Learning of agent A has failed. Reset weight parameter," indicating that the learning of the agent A has failed and prompting adjustment of the parameter (weight $\omega_i$) for the agent A.

At A in FIG. 13, to prompt adjustment of only the parameter for the reward for the agent A, the sliders 81 and 82 are set such that the slider 81 for the agent A (slider for adjusting the parameters for the reward for the agent A) is in an enabled state where the slider 81 can be operated, whereas the slider 82 for the agent B is in a disabled state where the slider 82 is prevented from being operated.

In this case, the operator is prevented from inadvertently operating the slider 82 for the agent B when the learning of the agent B has been progressing appropriately instead of having failed. Moreover, the operator can easily recognize that the slider 81 for the agent A is to be operated.

B in FIG. 13 illustrates a display example of the GUI displayed in a case where the change patterns of the reward graphs of the agents A and B are both the pattern p2 at B in FIG. 12.

In the case where the change patterns of the reward graphs of the agents A and B are both the pattern p2, since the learning of both the agents A and B has succeeded, an alert message at B in FIG. 13 is "Learning has converged. Reset weight parameters," indicating that the learning of both the agents A and B has succeeded and prompting adjustment of the parameters (weights $\omega_i$ and $V_i$) for the agents A and B.

Furthermore, at B in FIG. 13, both the slider 81 for the agent A and the slider 82 for the agent B are in the enabled state where the sliders can be operated.

Accordingly, the operator can easily recognize that the slider 81 for the agent A and the slider 82 for the agent B are to be operated.

C in FIG. 13 illustrates a display example of the GUI displayed in a case where the change pattern of the reward graph of the agent B is the pattern p3 at C in FIG. 12.

In the case where the change pattern of the reward graph of the agent B is the pattern p3, the learning of the agent B has failed under the current learning conditions, and an alert message at C in FIG. 13 is "Learning of agent B has failed. Reset weight parameter," indicating that the learning of the agent B has failed and prompting adjustment of the parameter (weight $V_i$) for the reward for the agent B.

At C in FIG. 13, to prompt adjustment of only the parameter for the reward for the agent B, the sliders 81 and 82 are set such that the slider 82 for the agent B is in the enabled state where the slider 82 can be operated, whereas the slider 81 for the agent A is in the disabled state where the slider 81 is prevented from being operated.

In this case, the operator is prevented from inadvertently operating the slider 81 for the agent A when the learning of the agent A has been progressing appropriately instead of having failed. The operator can further easily recognize that the slider 82 for the agent B is to be operated.

In FIG. 13, in a case where the change patterns of the reward graphs of the agents A and B are both the pattern p2 and the learning of both the agents A and B has succeeded, the alert is issued that displays the alert message such as "Learning has converged. Reset weight parameters," indicating, for example, the success of the learning (hereinafter also referred to as the success message) as illustrated at B in FIG. 13. However, the alert including the display of the success message can be individually issued for each of the agents A and B.

That is, for example, in a case where the change pattern of the reward graph of the agent A is the pattern p2 and the learning of the agent A has succeeded, an alert can be issued that displays the success message indicating, for example, the success of the learning of the agent A, regardless of the learning status of the agent B.

In this case, as is the case with A in FIG. 13, the sliders 81 and 82 are set such that the slider 81 for the agent A is in the enabled state, whereas the slider 82 for the agent B is in the disabled state.

Furthermore, for example, in a case where the change pattern of the reward graph of the agent B is the pattern p2 and the learning of the agent B has succeeded, an alert can be issued that displays the success message indicating, for example, the success of the learning of the agent B, regardless of the learning status of the agent A.

In this case, as is the case with C in FIG. 13, the sliders 81 and 82 are set such that the slider 82 for the agent B is in the enabled state, whereas the slider 81 for the agent A is in the disabled state.

<Alert Issuing Process>

FIG. 14 is a flowchart illustrating an example of an alert issuing process for issuing an alert as described for FIG. 12 and FIG. 13.

FIG. 15 is a flowchart continued from FIG. 14.

In the alert issuing process, in step S41, the learning status determining unit 34 acquires the reward graphs of the agents A and B for a latest prescribed period. The process proceeds to step S42.

In step S42, the learning status determining unit 34 determines the learning status of the agent A on the basis of the change pattern of the reward graph of the agent A. That is, in step S42, the learning status determining unit 34 determines whether the change pattern of the reward graph of the agent A is the pattern p3 at C in FIG. 12.

In step S42, in a case where the change pattern of the reward graph of the agent A is determined not to be the pattern p3, the process skips steps S43 to S46 to proceed to step S47.

Furthermore, in a case where the change pattern of the reward graph of the agent A is determined to be the pattern p3 in step S42, the agent A suspends the learning, and the process proceeds to step S43.

In step S43, the input/output control unit 36 sets, in a variable text used as an alert message, the message "Learning of agent A has failed. Reset weight parameter," indicating that the learning of the agent A has failed and prompting adjustment of the parameter (weight $\omega_i$) for the reward for the agent A.

Moreover, in step S43, the input/output control unit 36 causes the user I/F 40 to display the message set in the variable text used as an alert message, to issue the alert. The process proceeds to step S44.

In step S44, the input/output control unit 36 initializes activation of all the sliders 81 and 82 to the disabled state to set the sliders 81 and 82 to an operation disabled state. The process proceeds to step S45.

In step S45, the input/output control unit 36 sets the activation of the slider 81 for the agent A to the enabled state to set an operation enabled state. The process proceeds to step S45.

As described above, the display at A in FIG. 13 is provided, allowing the user to recognize that the learning of the agent A has failed and that the parameter for the reward for the agent A needs to be adjusted. The user can further operate the slider 81 for the agent A to adjust the parameter for the reward for the agent A.

In step S46, the input/output control unit 36 determines whether the user I/F 40 has been operated to restart the learning. In a case where the user I/F 40 is determined not to have been operated to restart the learning, the process returns to step S46.

Furthermore, in step S46, in a case where the user I/F 40 is determined to have been operated to restart the learning, the agent A restarts the learning, and the process proceeds to step S47.

In step S47, the learning status determining unit 34 determines the learning status of the agent B on the basis of the change pattern of the reward graph of the agent B. That is, in step S47, the learning status determining unit 34 determines whether the change pattern of the reward graph of the agent B is the pattern p3 at C in FIG. 12.

In step S47, in a case where the change pattern of the reward graph of the agent B is determined not to be the pattern p3, the process skips steps S48 to S51 to proceed to step S61 in FIG. 15.

Furthermore, in step S47, in a case where the change pattern of the reward graph of the agent B is determined to be the pattern p3, the agent B suspends the learning, and the process proceeds to step S48.

In step S48, the input/output control unit 36 sets, in a variable text used as an alert message, the message "Learning of agent B has failed. Reset weight parameter," indicating that the learning of the agent B has failed and prompting adjustment of the parameter (weight $\omega_i$) for the reward for the agent B.

Moreover, in step S48, the input/output control unit 36 causes the user I/F 40 to display the message set in the variable text used as an alert message, to issue the alert. The process proceeds to step S49.

In step S49, the input/output control unit 36 initializes activation of all the sliders 81 and 82 to the disabled state to set the sliders 81 and 82 to the operation disabled state. The process proceeds to step S50.

In step S50, the input/output control unit 36 sets the activation of the slider 81 for the agent B to the enabled state to set the operation enabled state. The process proceeds to step S50.

As described above, the display at C in FIG. 13 is provided, allowing the user to recognize that the learning of the agent B has failed and that the parameter for the reward for the agent B needs to be adjusted. The user can further operate the slider 82 for the agent B to adjust the parameter for the reward for the agent B.

In step S51, the input/output control unit 36 determines whether the user I/F 40 has been operated to restart the learning. In a case where the user I/F 40 is determined not to have been operated to restart the learning, the process returns to step S51.

Furthermore, in step S51, in a case where the user I/F 40 is determined to have been operated to restart the learning, the agent B restarts the learning, and the process proceeds to step S61 in FIG. 15.

In step S61 in FIG. 15, the learning status determining unit 34 determines the learning statuses of the agents A and B on the basis of the change patterns of the reward graphs of the agents A and B. That is, in step S42, the learning status determining unit 34 determines whether the change patterns of the reward graphs of the agents A and B are both the pattern p2 at B in FIG. 12.

In step S61, in a case where one of the change patterns of the reward graphs of the agents A and B is determined not to be the pattern p2 or neither of the change patterns is determined to the pattern p2, the process returns to step S41 in FIG. 14.

Furthermore, in step S61, in a case where the change patterns of the reward graphs of the agents A and B are determined to be both the pattern p2, the agents A and B suspend the learning, and the process proceeds to step S62.

In step S62, the input/output control unit 36 sets, in the variable text used as an alert message, the message "Learning has converged. Reset weight parameters," indicating that the learning of both the agents A and B has succeeded and prompting adjustment of the parameters (weights $\omega_i$ and $V_i$) for the rewards for the agents A and B.

Moreover, in step S62, the input/output control unit 36 causes the user I/F 40 to display the message set in the variable text used as an alert message, to issue the alert. The process proceeds to step S63.

In step S63, the input/output control unit 36 initializes activation of all the sliders 81 and 82 to the enabled state to set the sliders 81 and 82 to the operation enabled state. The process proceeds to step S64.

As described above, the display at B in FIG. 13 is provided, allowing the user to recognize that the learning of the agents A and B has converged and that the parameters for the rewards for the agents A and B can adjusted as needed. The user can further operate the slider 81 for the agent A to adjust the parameter for the reward for the agent A, while operating the slider 82 for the agent B to adjust the parameter for the reward for the agent B.

In step S64, the input/output control unit 36 determines whether the user I/F 40 has been operated to restart the learning. In a case where the user I/F 40 is determined not to have been operated to restart the learning, the process returns to step S64.

Furthermore, in step S64, in a case where the user I/F 40 is determined to have been operated to restart the learning, the agents A and B restart the learning. The process returns from step S64 to step S41 in FIG. 14, and a similar process is repeated.

In the description of the present embodiment, the agent of a self-driving vehicle is adopted as the agent A, the agent of another vehicle such as a bicycle, a human being, or the like is adopted as the agent B, and the present technique is applied to the field of self-driving involving learning of the action decision rule for self-driving. However, the present technique is also applicable to learning of action decision rules in various fields other than the field of self-driving.

That is, the present technique is applicable to the fields of vaccine development, improvement in farm produce varieties, and the like.

For example, in the field of vaccine development, an agent of a vaccine is adopted as the agent A, and an agent of a virus is adopted as the agent B. This allows learning of an action decision rule for a vaccine effective against the virus.

Furthermore, for example, in the field of improvement in farm produce varieties, an agent of a certain species (new species) of farm produce is adopted as the agent A, and an agent of a pest is adopted as the agent B. This allows learning of an action decision rule for a specifies resistant to the pest.

<Description of Computer to which Present Technique is Applied>

Next, the above-described series of processes can be executed by hardware or by software. In a case where the series of processes is executed by software, a program included in the software is installed in a general-purpose computer or the like.

FIG. 16 is block diagram illustrating an example of a configuration of an embodiment of a computer in which a program executing the above-described series of processes is installed.

The program can be pre-recorded in a hard disk 105 or a ROM 103 used as a recording medium built into the computer.

Alternatively, the program can be stored (recorded) in a removable recording medium 111. Such a removable recording medium 111 can be provided as what is called package software. Here, the removable recording medium 111 is, for example, a flexible disk, a CD-ROM (Compact Disc Read Only Memory), an MO (Magneto Optical) disk, a DVD (Digital Versatile Disc), a magnetic disk, and a semiconductor memory.

The program can be installed into the computer from the removable recording medium 111 as described above or downloaded into the computer via a communication network or a broadcasting network and installed into the built-in hard disk 105. That is, the program can be, for example, transferred by radio from a download site to the computer via an artificial satellite for digital satellite broadcasting or transferred by wire to the computer via a network such as LAN (Local Area Network) and the Internet.

The computer includes a built-in CPU (Central Processing Unit) 102, and the CPU 102 connects to an input/output interface 110 via a bus 101.

When receiving, via the input/output interface 110, an instruction given by the user by, for example, operation of the input unit 107, the CPU 102 executes, in accordance with the instruction, the program stored in a ROM (Read Only Memory) 103. Alternatively, the CPU 102 loads the program stored in the hard disk 105 into a RAM (Random Access Memory) 104 and executes the program in the RAM 104.

The CPU 102 thus executes the process in accordance with the above-described flowcharts or executes the process using the configurations in the above-described block diagrams. The CPU 102 causes, as necessary, process results to be output from an output unit 106 via the input/output interface 110 or transmitted from a communication unit 108 and further, for example, recorded in the hard disk 105.

The input unit 107 includes a keyboard, a mouse, a microphone, or the like. The output unit 106 includes an LCD (Liquid Crystal Display), a speaker, or the like.

Here, in the present specification, the process executed by the computer in accordance with the program need not necessarily be executed in a chronological order in the order described in the flowcharts. That is, the process executed by the computer in accordance with the program includes processes executed in parallel or discretely (for example, parallel processing or object-based processing).

Furthermore, the program may be processed by one computer (processor) or processed in a distributed manner by a plurality of computers. Moreover, the program may be transferred to a remote computer for execution.

Moreover, in the present specification, the system means a set of a plurality of components (apparatuses, modules (parts), or the like) regardless of whether or not all the components are located in an identical housing. Accordingly, examples of the system include a plurality of apparatuses housed in separate housings and connected together via the network, and one apparatus with a plurality of modules housed in one housing.

The embodiment of the present technique is not limited to the above-described embodiments, and many variations can be made to the embodiments without departing from the scope of the present technique.

For example, the present technique can be configured as cloud computing in which one function is shared by a plurality of apparatuses via the network and in which the apparatuses cooperate in executing processes.

Furthermore, the steps described using the above-described flowcharts can be executed by one apparatus or shared by a plurality of apparatuses for execution.

Moreover, in a case where one step includes a plurality of processes, the plurality of processes included in the one step can be executed by one apparatus or shared by a plurality of apparatuses for execution.

The effects described herein are only illustrative and are not limited, and other effects may be produced.

The present technique can be configured as described below.

<1> An information processing apparatus including:

a simulator environment generating unit generating a simulator environment simulating a real world; and
a reward providing unit for a first agent and a second agent taking action in the simulator environment and learning an action decision rule according to a reward for the action, the reward providing unit

providing the first agent with the reward in accordance with a prescribed reward definition, and
providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

<2> The information processing apparatus set forth in <1>, in which the reward providing unit adjusts parameters for the rewards in accordance with operation of a user.
<3> The information processing apparatus set forth in <2>, further including:
a display control unit executing display control causing display of a GUI (Graphical User Interface) adjusting the parameters for the rewards.
<4> The information processing apparatus set forth in <2> or <3>, further including:
an issuance control unit controlling issuance of an alert prompting adjustment of the parameters for the rewards according to learning statuses of the first agent and the second agent.
<5> The information processing apparatus set forth in <4>, further including:
a determining unit determining the learning statuses according to change patterns of the rewards.
<6> The information processing apparatus set forth in <4> or <5>, in which the alert is issued in a case where the first agent or the second agent fails in learning or in a case where the first agent or the second agent succeeds in learning.
<7> An information processing method including:

generating a simulator environment simulating a real world; and
for a first agent and a second agent taking action in the simulator environment and learning an action decision rule according to a reward for the action,

providing the first agent with the reward in accordance with a prescribed reward definition, and
providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

[Reference Signs List]

10 Agent, 11 Experiment DB, 12 Learning unit, 13 Action deciding unit, 30 Simulator, 31 Simulator environment providing unit, 32 Simulator environment generating unit, 33 Reward providing unit, 34 Learning status determining unit, 36 Input/output control unit, 40 User I/F, 61 Action planning unit, 62 Surrounding-environment information acquiring unit, 63 Data acquiring unit, 64 Database, 65 Learning unit, 66 Action deciding unit, 67 Action control unit, 101 Bus, 102 CPU, 103 ROM, 104 RAM, 105 Hard disk, 106 Output unit, 107 Input unit, 108 Communication unit, 109 Drive, 110 Input/output interface, 111 Removable recording medium

## Claims

1. An information processing apparatus comprising:

a simulator environment generating unit generating a simulator environment simulating a real world; and
a reward providing unit for a first agent and a second agent taking action in the simulator environment and learning an action decision rule according to a reward for the action, the reward providing unit

providing the first agent with the reward in accordance with a prescribed reward definition, and
providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

2. The information processing apparatus according to claim 1, wherein the reward providing unit adjusts parameters for the rewards in accordance with operation of a user.

3. The information processing apparatus according to claim 2, further comprising:

a display control unit executing display control causing display of a GUI (Graphical User Interface) adjusting the parameters for the rewards.

**4.** The information processing apparatus according to claim 2, further comprising:
an issuance control unit controlling issuance of an alert prompting adjustment of the parameters for the rewards according to learning statuses of the first agent and the second agent.

**5.** The information processing apparatus according to claim 4, further comprising:
a determining unit determining the learning statuses according to change patterns of the rewards.

**6.** The information processing apparatus according to claim 4, wherein the alert is issued in a case where the first agent or the second agent fails in learning or in a case where the first agent or the second agent succeeds in learning.

**7.** An information processing method comprising:

generating a simulator environment simulating a real world; and
for a first agent and a second agent taking action in the simulator environment and learning an action decision rule according to a reward for the action,

providing the first agent with the reward in accordance with a prescribed reward definition, and
providing the second agent with the reward in accordance with an opposing reward definition opposing the prescribed reward definition, the opposing reward definition causing a resultant reward to be increased in a case where the second agent acts to bring about a situation where the reward for the first agent is reduced and causing a resultant reward to be reduced in a case where the second agent acts to increase the reward for the first agent.

FIG. 1

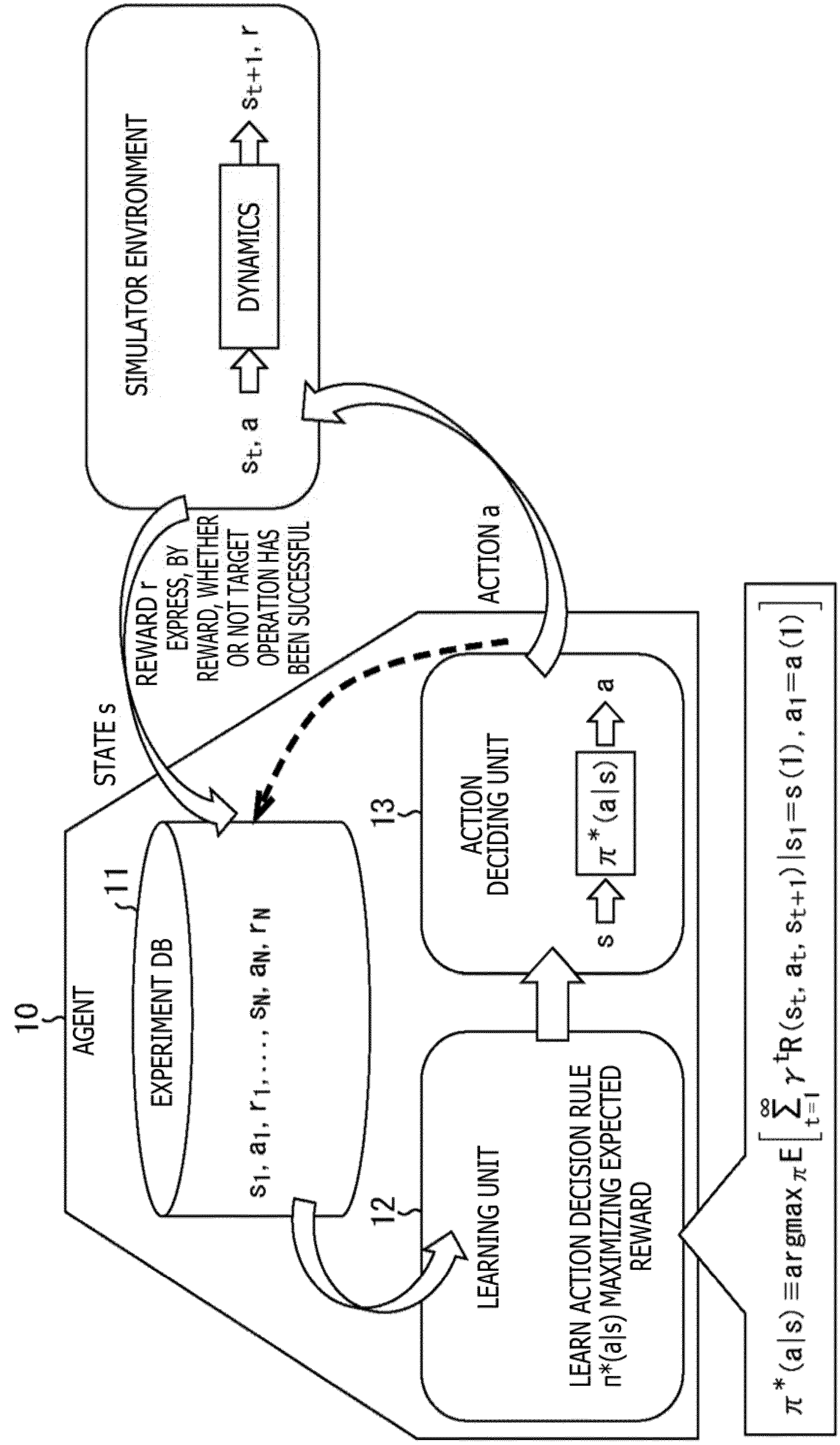
SIMULATOR ENVIRONMENT
$s_t$, a
DYNAMICS
$s_{t+1}$, r
REWARD r
EXPRESS, BY REWARD, WHETHER OR NOT TARGET OPERATION HAS BEEN SUCCESSFUL
ACTION a
STATE s
10
AGENT
11
EXPERIMENT DB
$s_1, a_1, r_1, \ldots, s_N, a_N, r_N$
12
LEARNING UNIT
LEARN ACTION DECISION RULE π*(a|s) MAXIMIZING EXPECTED REWARD
13
ACTION DECIDING UNIT
s
$\pi^*(a|s)$
a
$\pi^*(a|s) \equiv \mathrm{argmax}_\pi E\left[\sum_{t=1}^{\infty} \gamma^t R(s_t, a_t, s_{t+1}) \,|\, s_1 = s(1), a_1 = a(1)\right]$

FIG. 2

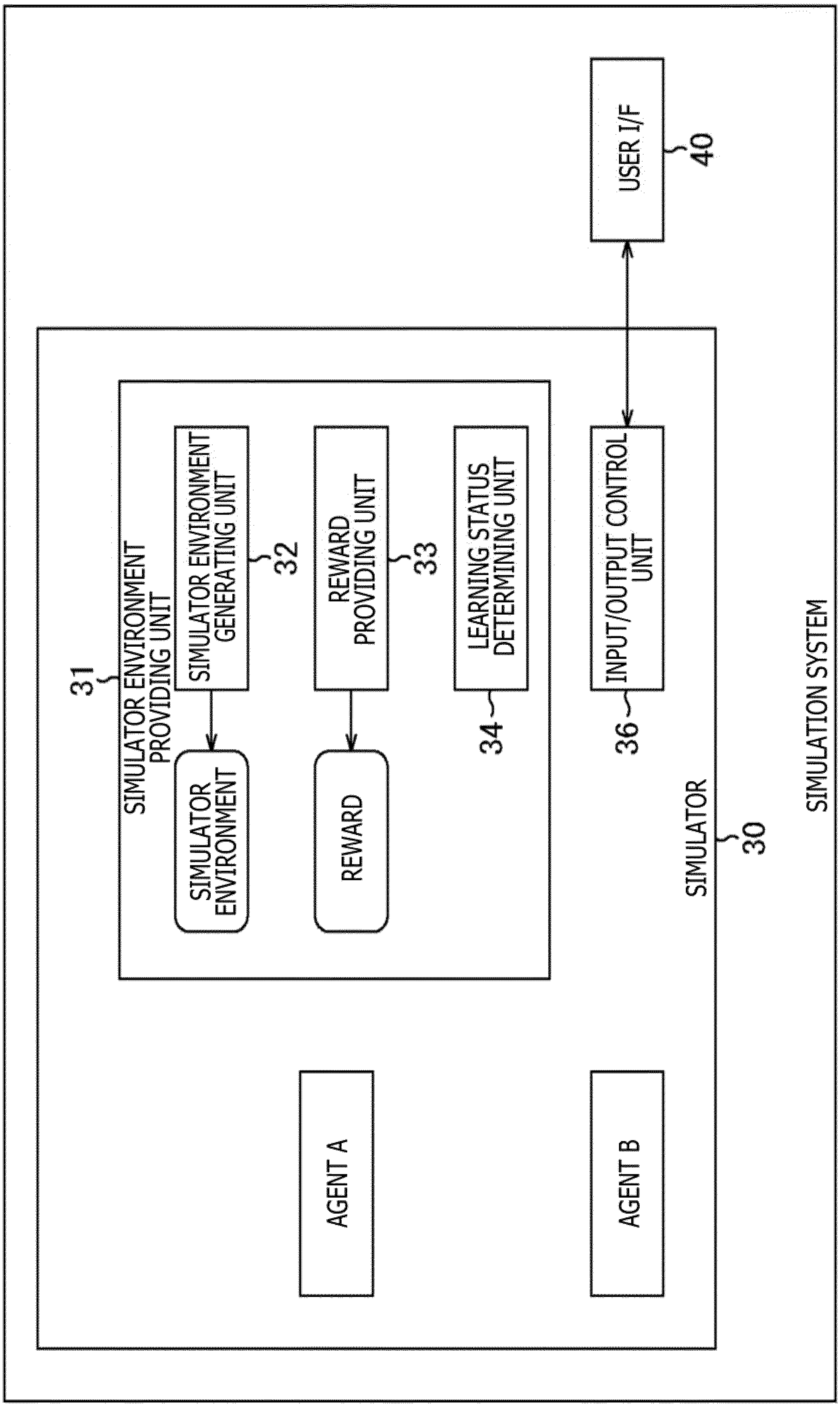
SIMULATION SYSTEM
SIMULATOR
30
SIMULATOR ENVIRONMENT PROVIDING UNIT
31
SIMULATOR ENVIRONMENT GENERATING UNIT
32
REWARD PROVIDING UNIT
33
LEARNING STATUS DETERMINING UNIT
34
INPUT/OUTPUT CONTROL UNIT
36
SIMULATOR ENVIRONMENT
REWARD
AGENT A
AGENT B
USER I/F
40

FIG. 3

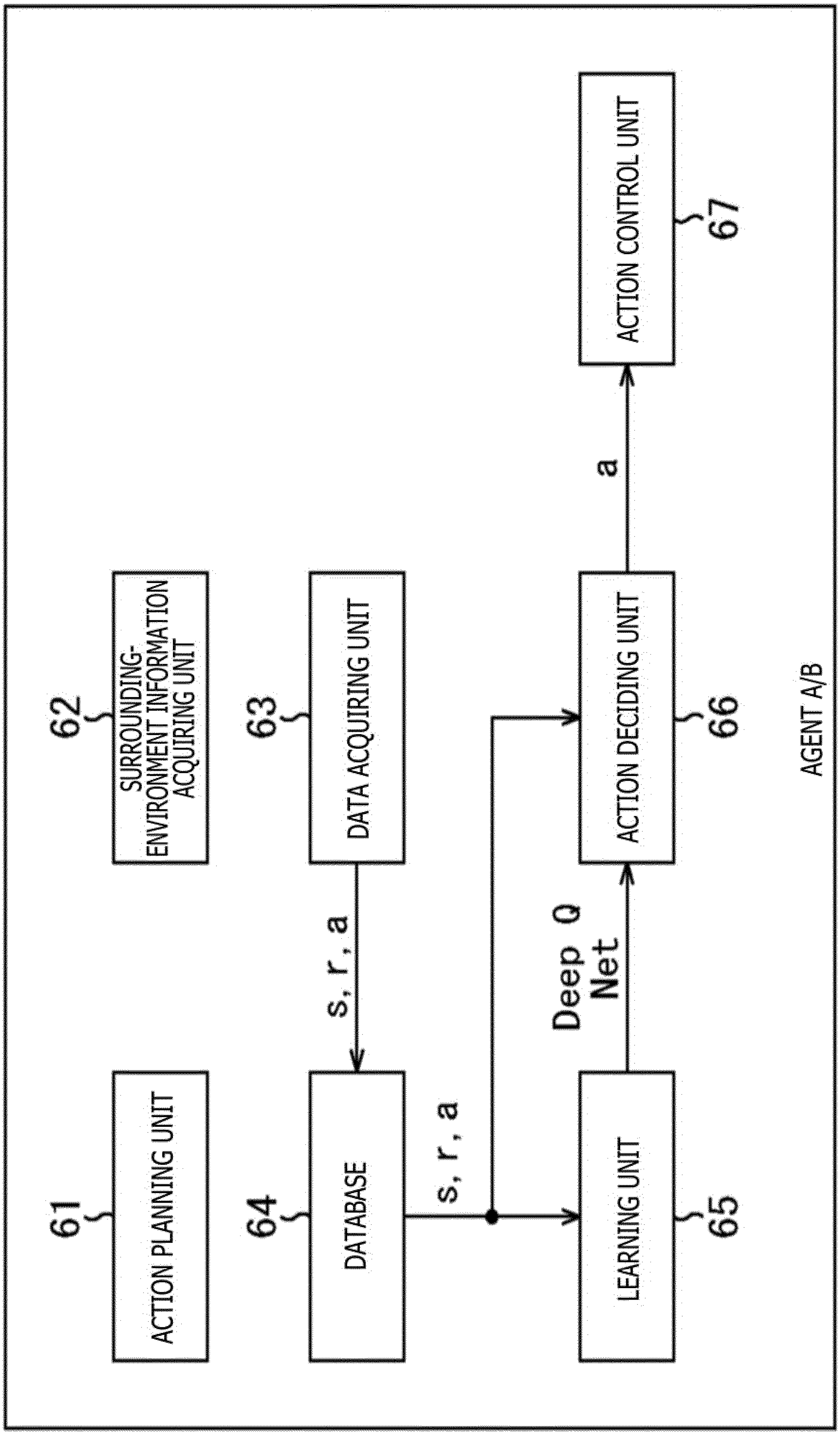
61
ACTION PLANNING UNIT
62
SURROUNDING-ENVIRONMENT INFORMATION ACQUIRING UNIT
63
DATA ACQUIRING UNIT
s, r, a
64
DATABASE
s, r, a
65
LEARNING UNIT
Deep Q Net
66
ACTION DECIDING UNIT
a
67
ACTION CONTROL UNIT
AGENT A/B

FIG.4

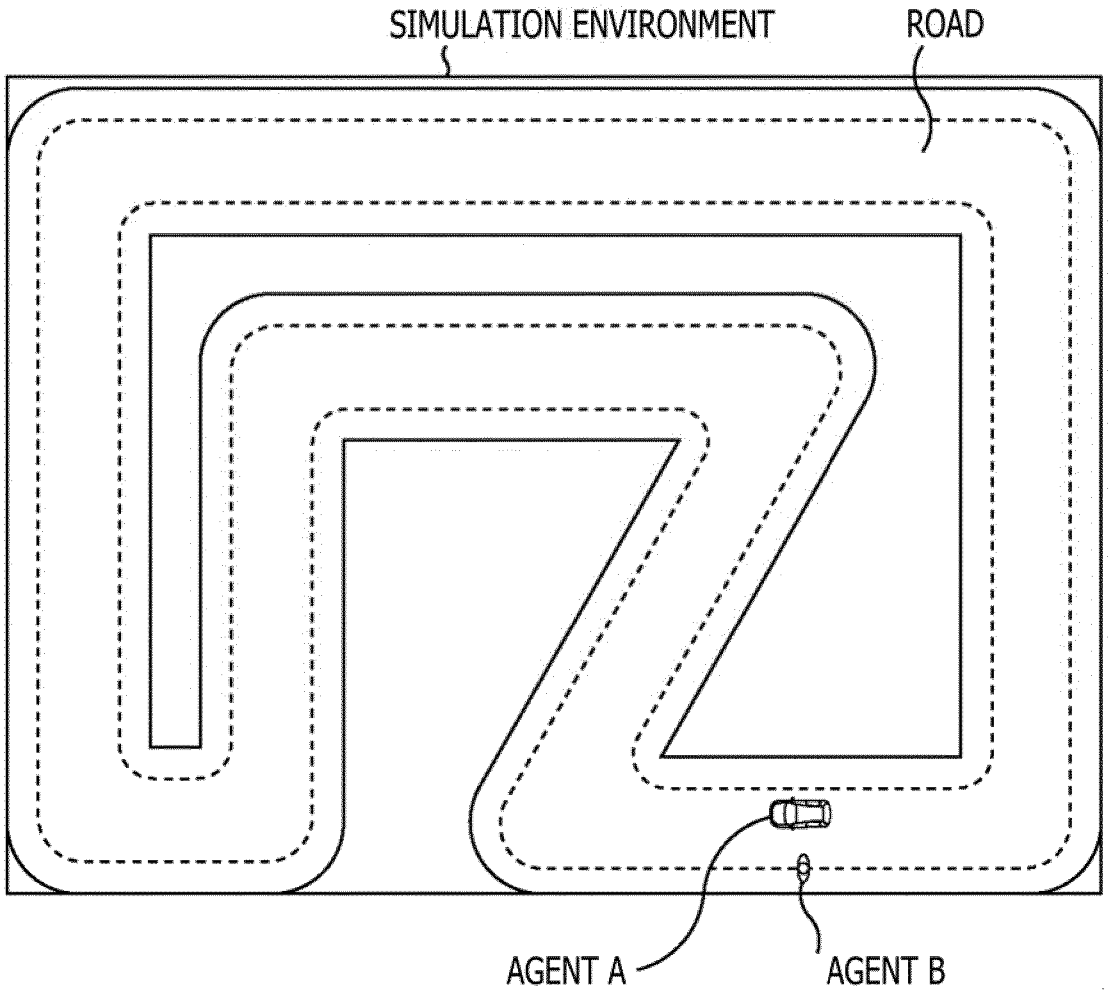

FIG. 5

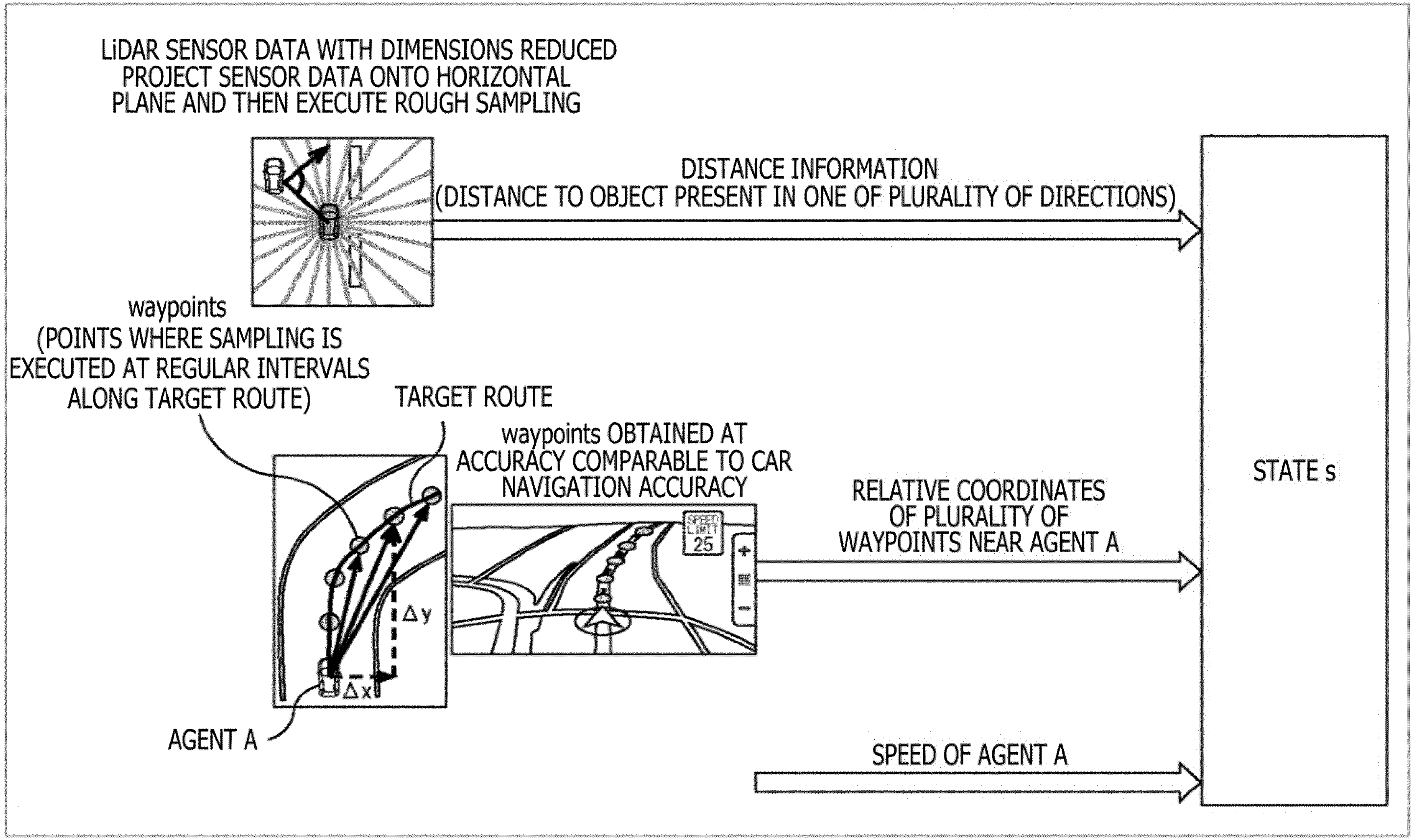
LiDAR SENSOR DATA WITH DIMENSIONS REDUCED
PROJECT SENSOR DATA ONTO HORIZONTAL
PLANE AND THEN EXECUTE ROUGH SAMPLING
DISTANCE INFORMATION
(DISTANCE TO OBJECT PRESENT IN ONE OF PLURALITY OF DIRECTIONS)
waypoints
(POINTS WHERE SAMPLING IS
EXECUTED AT REGULAR INTERVALS
ALONG TARGET ROUTE)
TARGET ROUTE
waypoints OBTAINED AT
ACCURACY COMPARABLE TO CAR
NAVIGATION ACCURACY
SPEED LIMIT 25
Δy
Δx
AGENT A
RELATIVE COORDINATES
OF PLURALITY OF
WAYPOINTS NEAR AGENT A
SPEED OF AGENT A
STATE s

FIG. 6

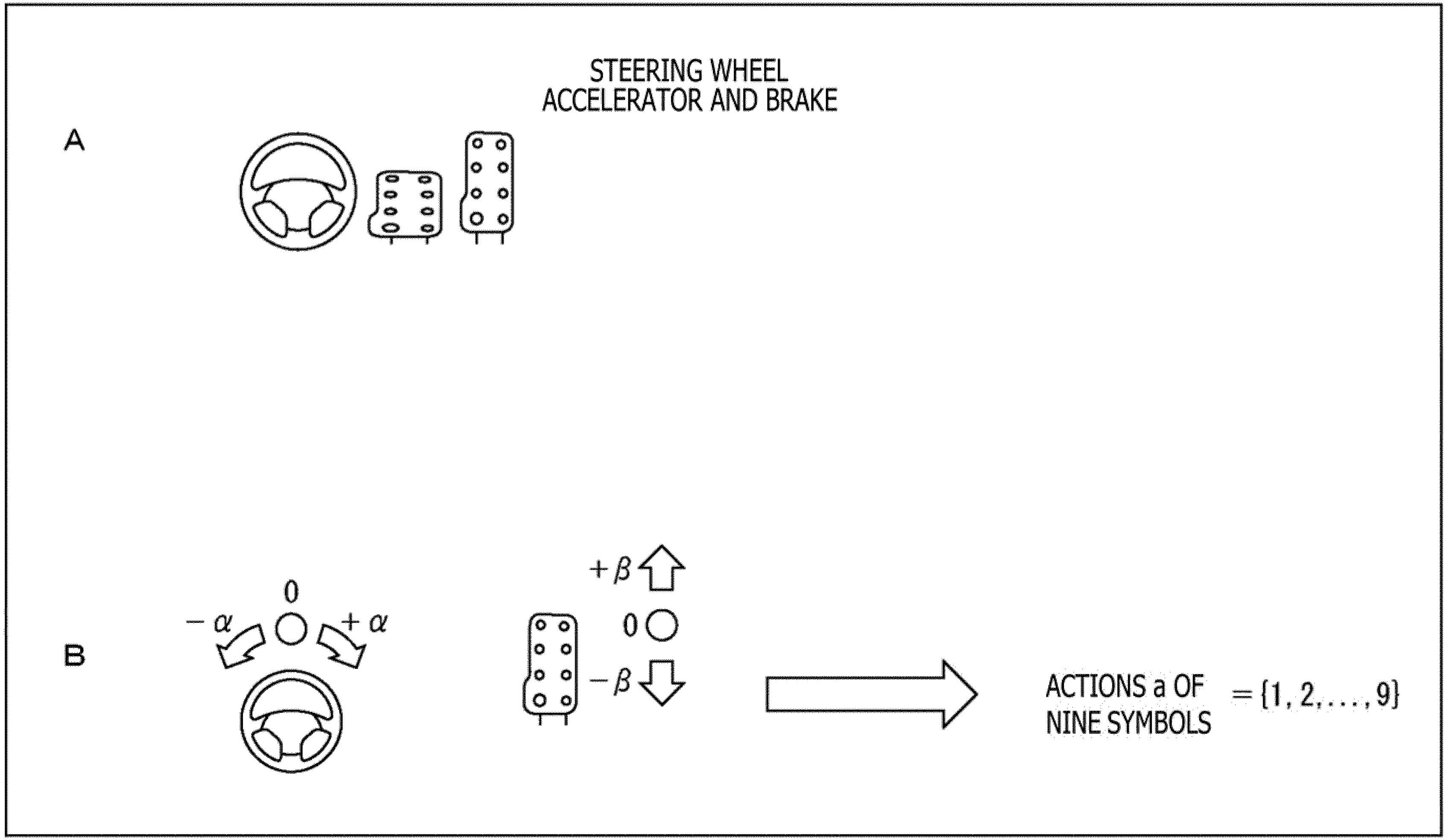
A
STEERING WHEEL
ACCELERATOR AND BRAKE
B
0
− α
+ α
+ β
0
− β
ACTIONS a OF
NINE SYMBOLS
= {1, 2, . . . , 9}

FIG.7

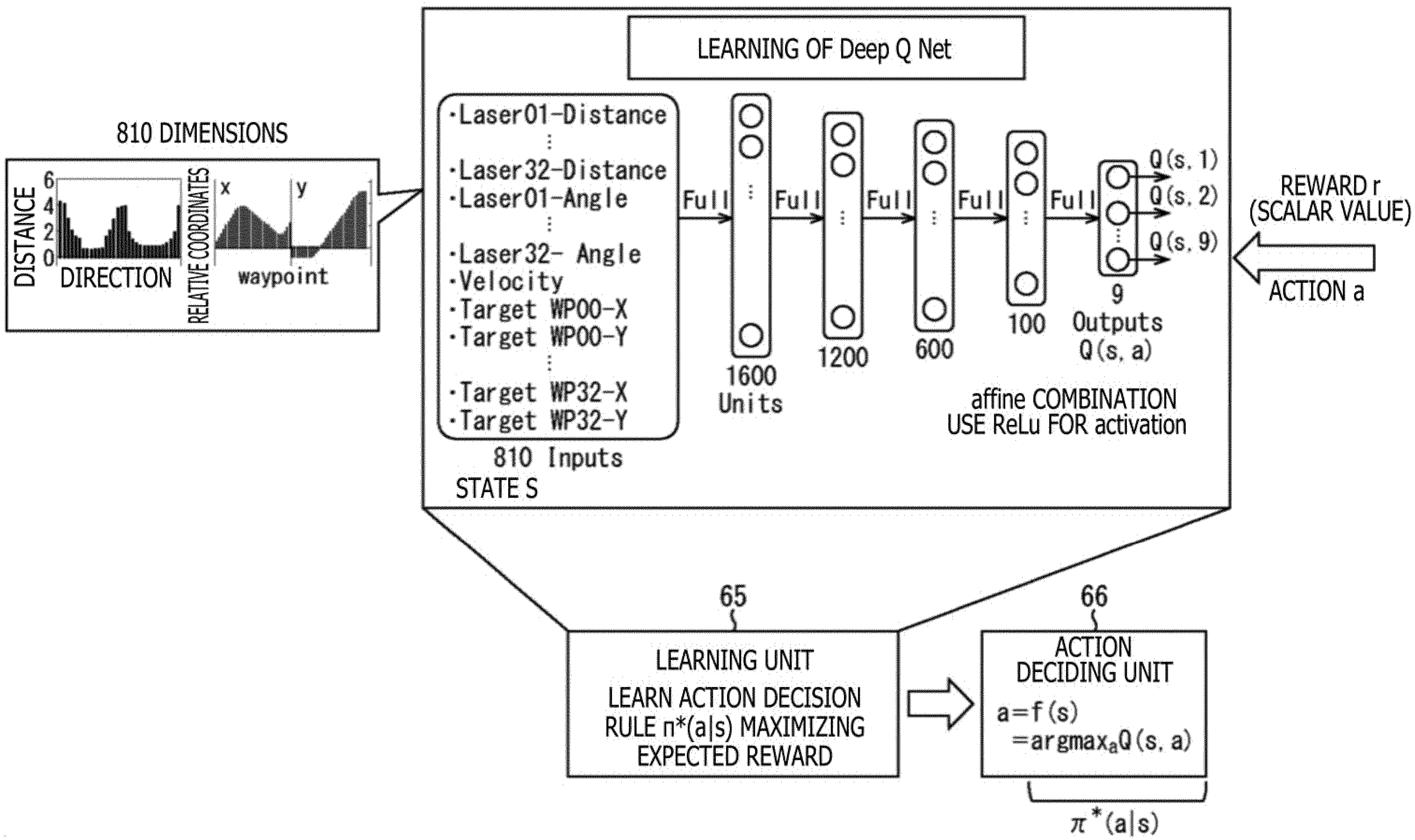
810 DIMENSIONS
DISTANCE
6
4
2
0
DIRECTION
RELATIVE COORDINATES
x
y
waypoint
LEARNING OF Deep Q Net
·Laser01-Distance
·Laser32-Distance
·Laser01-Angle
·Laser32- Angle
·Velocity
·Target WP00-X
·Target WP00-Y
·Target WP32-X
·Target WP32-Y
810 Inputs
STATE S
Full
1600
Units
1200
600
100
9
Outputs
Q(s, a)
Q(s, 1)
Q(s, 2)
Q(s, 9)
affine COMBINATION
USE ReLu FOR activation
REWARD r
(SCALAR VALUE)
ACTION a
65
LEARNING UNIT
LEARN ACTION DECISION RULE π*(a|s) MAXIMIZING EXPECTED REWARD
66
ACTION DECIDING UNIT
a=f(s)
=argmaxaQ(s, a)
π*(a|s)

FIG. 8

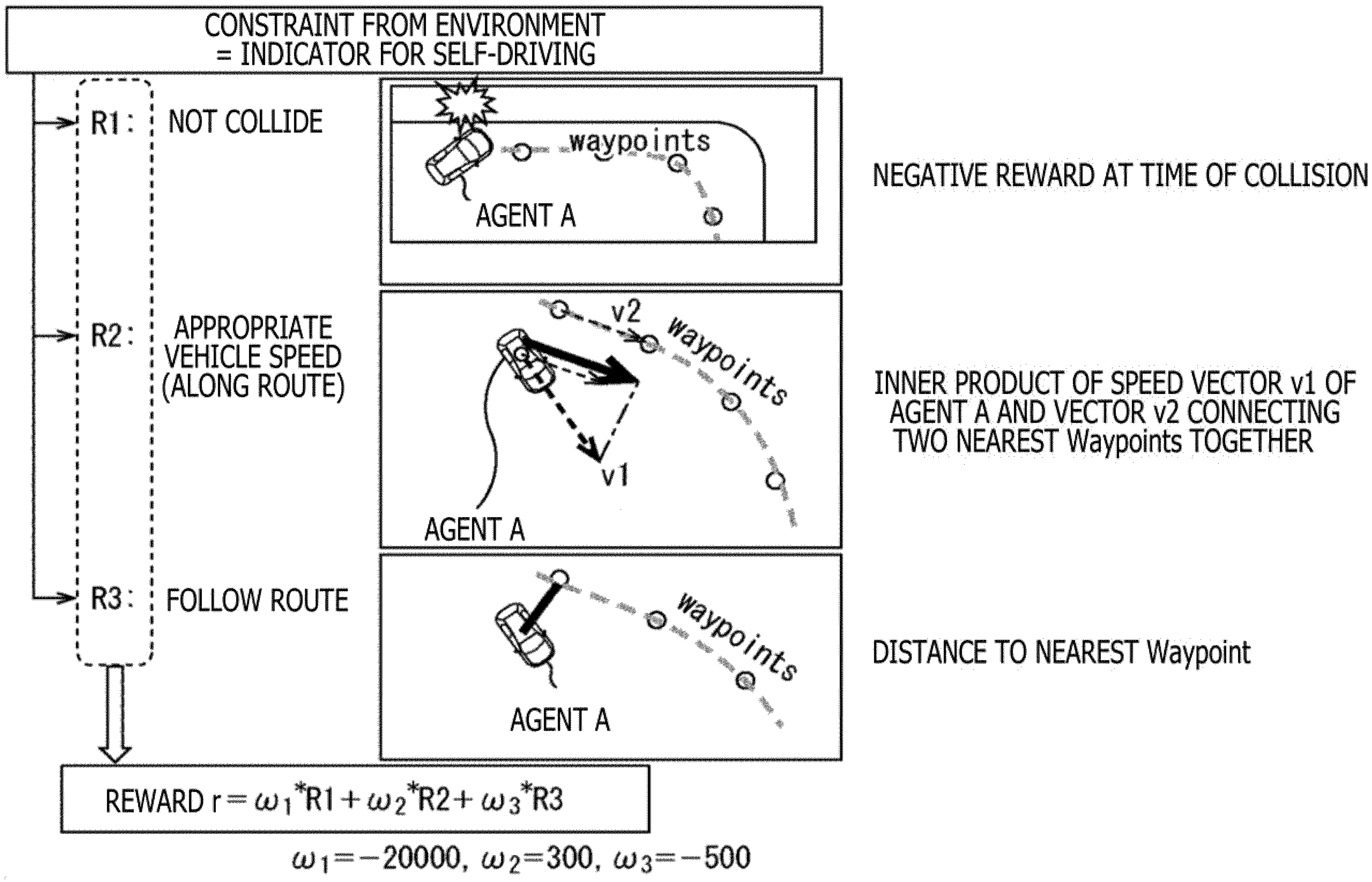
CONSTRAINT FROM ENVIRONMENT
= INDICATOR FOR SELF-DRIVING
R1 : NOT COLLIDE
waypoints
AGENT A
NEGATIVE REWARD AT TIME OF COLLISION
R2 : APPROPRIATE VEHICLE SPEED (ALONG ROUTE)
v2
waypoints
v1
AGENT A
INNER PRODUCT OF SPEED VECTOR v1 OF AGENT A AND VECTOR v2 CONNECTING TWO NEAREST Waypoints TOGETHER
R3 : FOLLOW ROUTE
waypoints
AGENT A
DISTANCE TO NEAREST Waypoint
REWARD r = ω1*R1 + ω2*R2 + ω3*R3
ω1=−20000, ω2=300, ω3=−500

FIG. 9

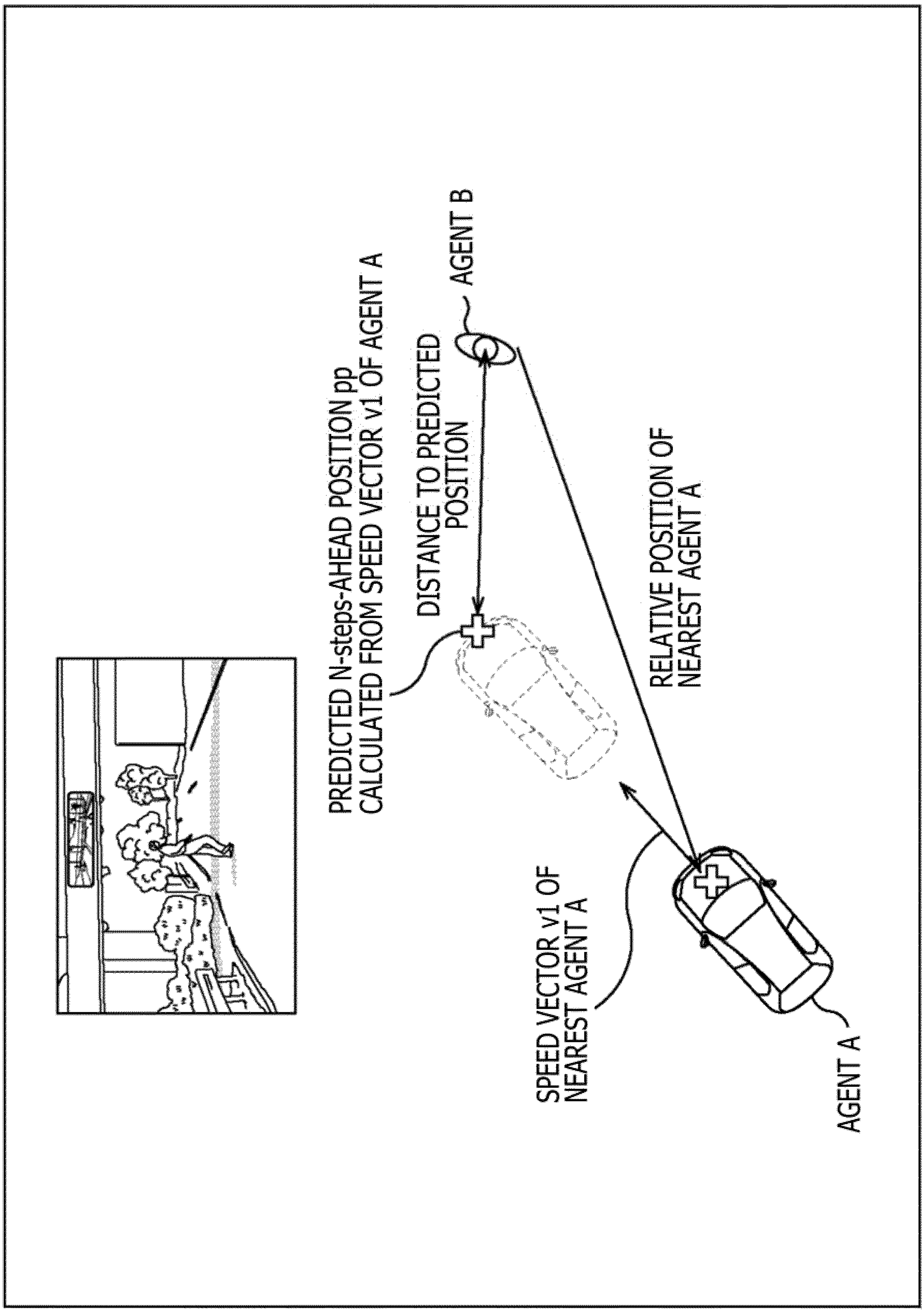
PREDICTED N-steps-AHEAD POSITION pp
CALCULATED FROM SPEED VECTOR v1 OF AGENT A
DISTANCE TO PREDICTED
POSITION
AGENT B
RELATIVE POSITION OF
NEAREST AGENT A
SPEED VECTOR v1 OF
NEAREST AGENT A
AGENT A

FIG. 10

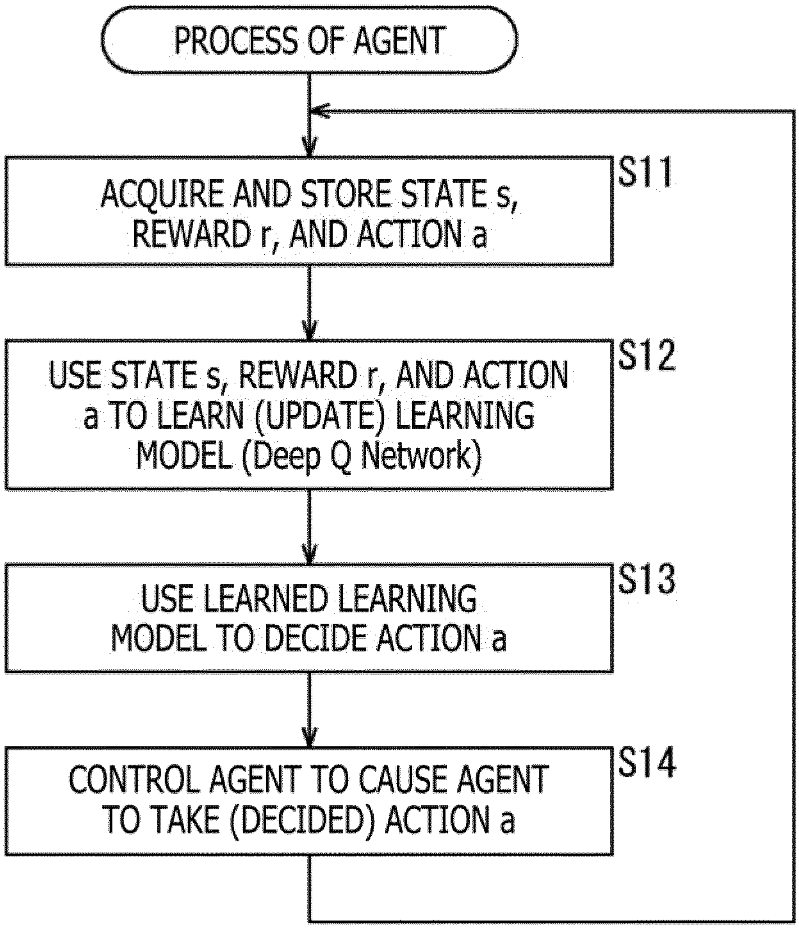
PROCESS OF AGENT
ACQUIRE AND STORE STATE s, REWARD r, AND ACTION a
S11
USE STATE s, REWARD r, AND ACTION a TO LEARN (UPDATE) LEARNING MODEL (Deep Q Network)
S12
USE LEARNED LEARNING MODEL TO DECIDE ACTION a
S13
CONTROL AGENT TO CAUSE AGENT TO TAKE (DECIDED) ACTION a
S14

FIG. 11

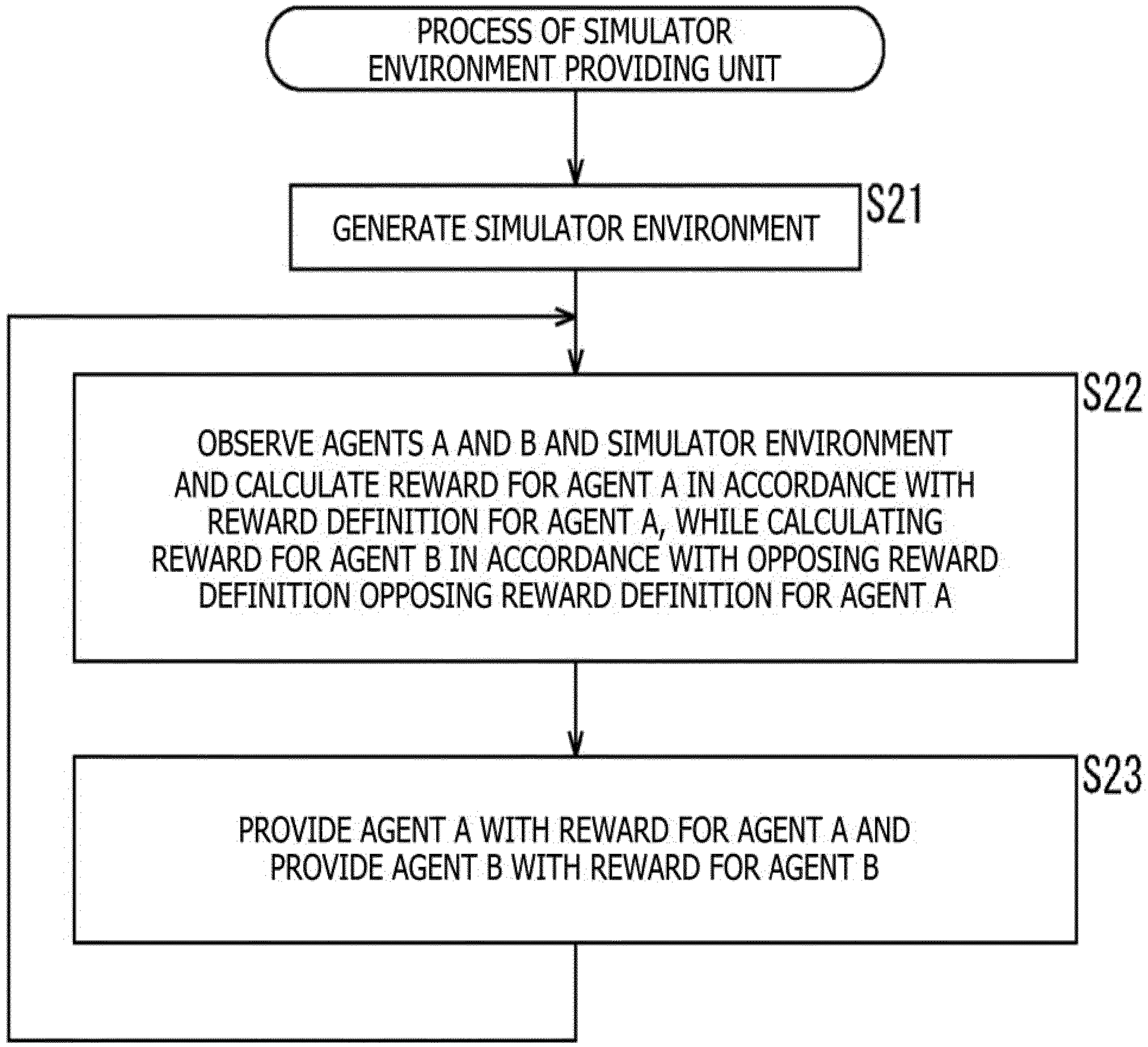
PROCESS OF SIMULATOR ENVIRONMENT PROVIDING UNIT
GENERATE SIMULATOR ENVIRONMENT
S21
OBSERVE AGENTS A AND B AND SIMULATOR ENVIRONMENT AND CALCULATE REWARD FOR AGENT A IN ACCORDANCE WITH REWARD DEFINITION FOR AGENT A, WHILE CALCULATING REWARD FOR AGENT B IN ACCORDANCE WITH OPPOSING REWARD DEFINITION OPPOSING REWARD DEFINITION FOR AGENT A
S22
PROVIDE AGENT A WITH REWARD FOR AGENT A AND PROVIDE AGENT B WITH REWARD FOR AGENT B
S23

FIG. 12

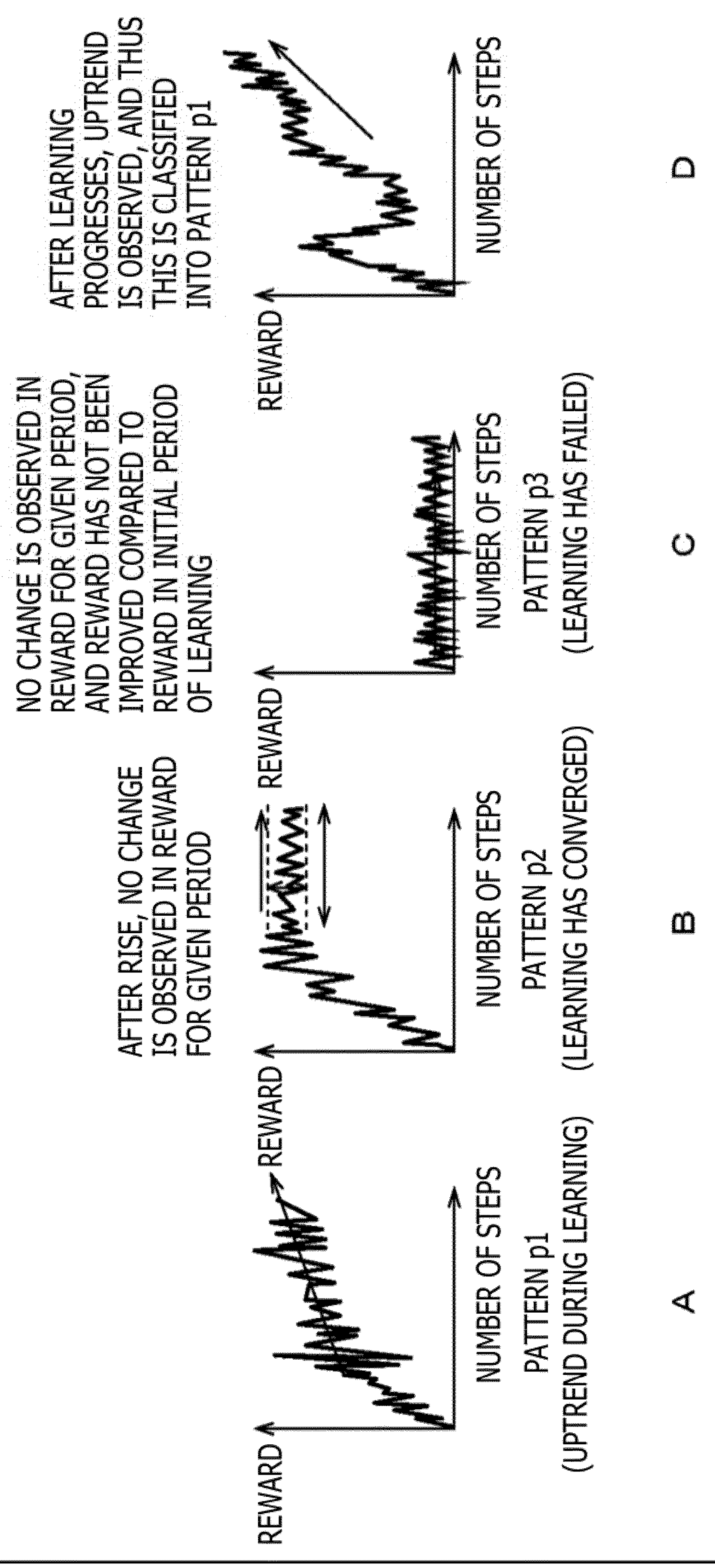
REWARD
NUMBER OF STEPS
PATTERN p1
(UPTREND DURING LEARNING)
A
AFTER RISE, NO CHANGE IS OBSERVED IN REWARD FOR GIVEN PERIOD
REWARD
NUMBER OF STEPS
PATTERN p2
(LEARNING HAS CONVERGED)
B
NO CHANGE IS OBSERVED IN REWARD FOR GIVEN PERIOD, AND REWARD HAS NOT BEEN IMPROVED COMPARED TO REWARD IN INITIAL PERIOD OF LEARNING
REWARD
NUMBER OF STEPS
PATTERN p3
(LEARNING HAS FAILED)
C
AFTER LEARNING PROGRESSES, UPTREND IS OBSERVED, AND THUS THIS IS CLASSIFIED INTO PATTERN p1
REWARD
NUMBER OF STEPS
D

FIG.13

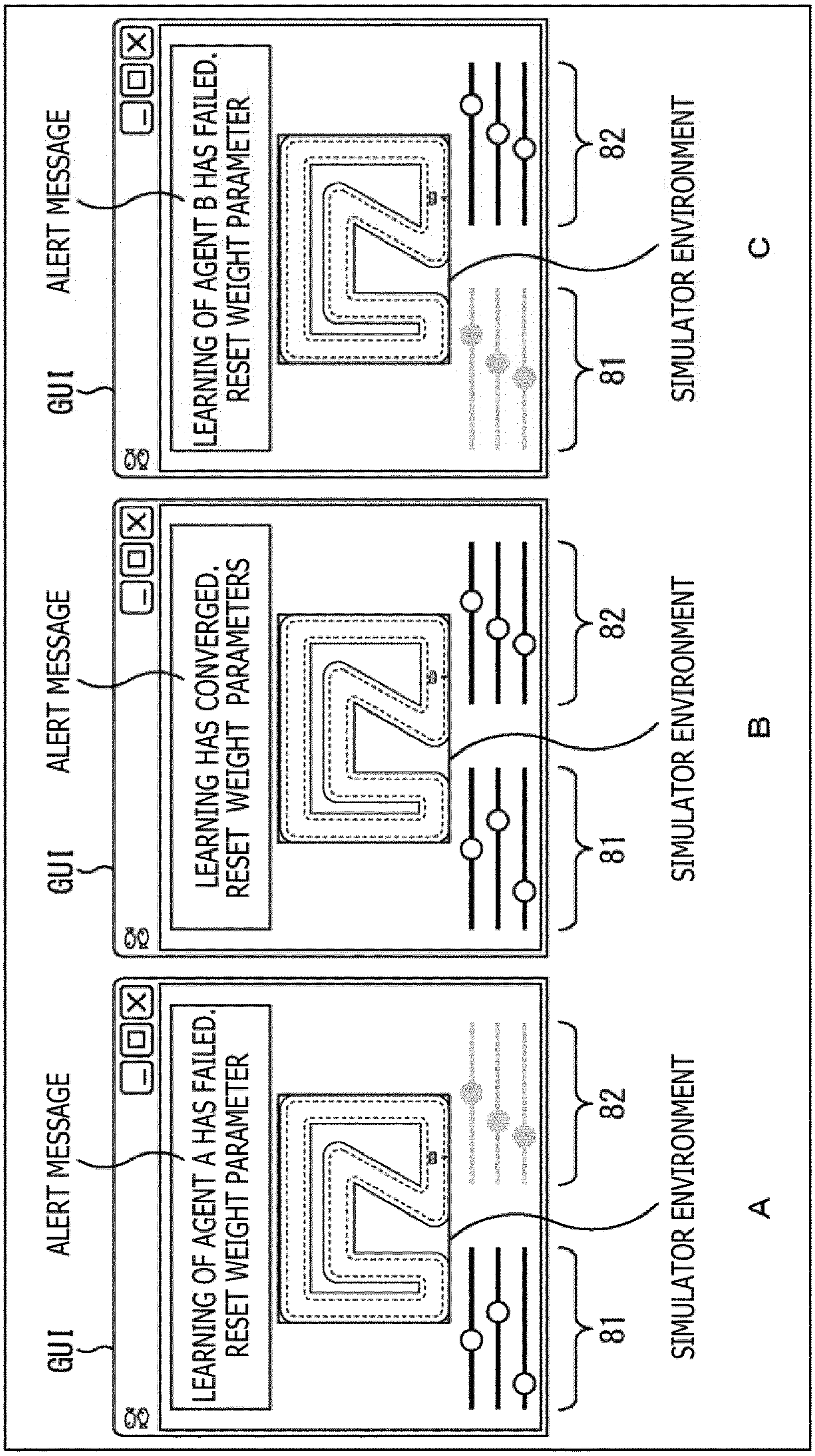
GUI
ALERT MESSAGE
LEARNING OF AGENT A HAS FAILED.
RESET WEIGHT PARAMETER
81
82
SIMULATOR ENVIRONMENT
A
GUI
ALERT MESSAGE
LEARNING HAS CONVERGED.
RESET WEIGHT PARAMETERS
81
82
SIMULATOR ENVIRONMENT
B
GUI
ALERT MESSAGE
LEARNING OF AGENT B HAS FAILED.
RESET WEIGHT PARAMETER
81
82
SIMULATOR ENVIRONMENT
C

FIG.14

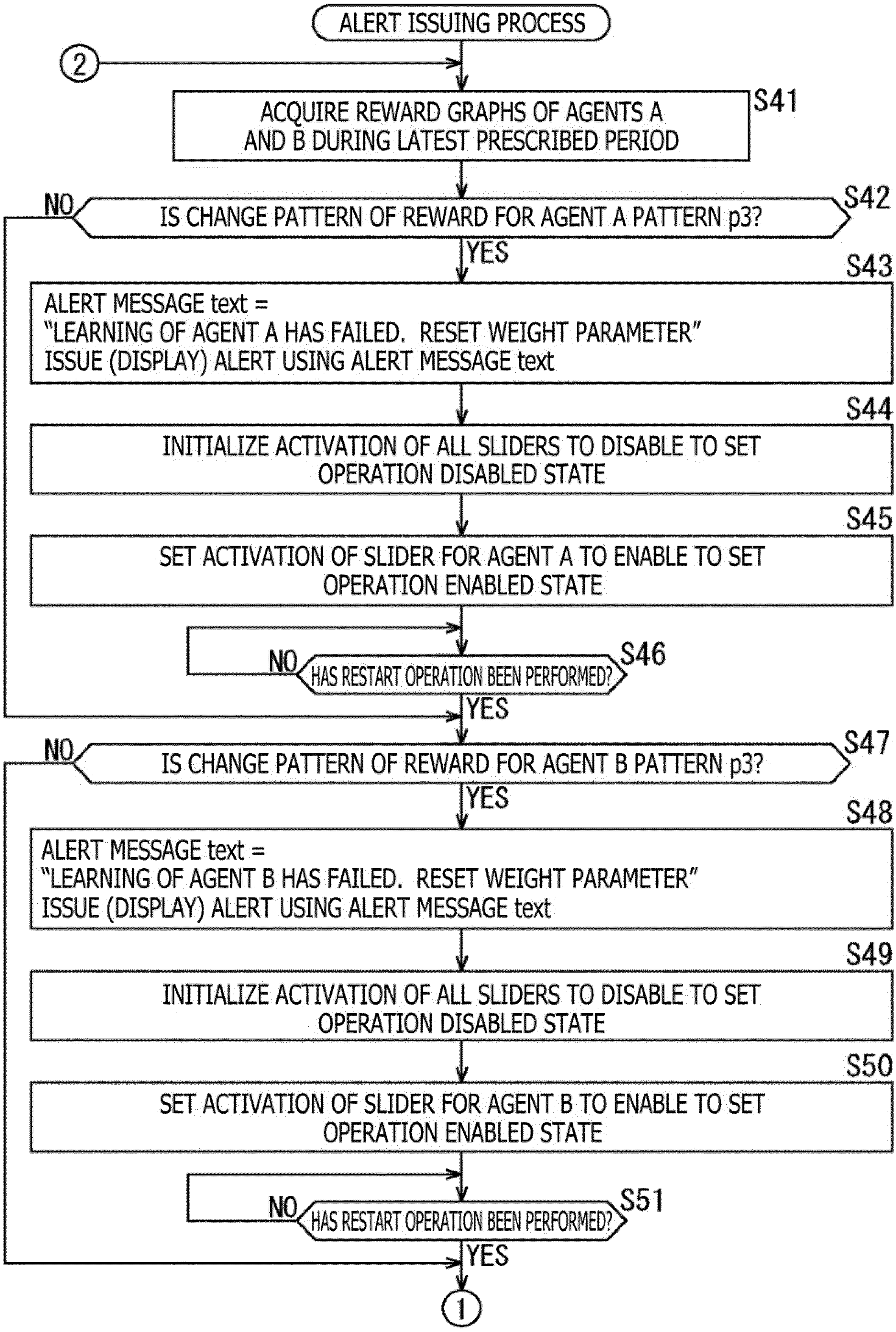
ALERT ISSUING PROCESS
2
ACQUIRE REWARD GRAPHS OF AGENTS A AND B DURING LATEST PRESCRIBED PERIOD
S41
IS CHANGE PATTERN OF REWARD FOR AGENT A PATTERN p3?
S42
NO
YES
S43
ALERT MESSAGE text =
"LEARNING OF AGENT A HAS FAILED. RESET WEIGHT PARAMETER"
ISSUE (DISPLAY) ALERT USING ALERT MESSAGE text
S44
INITIALIZE ACTIVATION OF ALL SLIDERS TO DISABLE TO SET OPERATION DISABLED STATE
S45
SET ACTIVATION OF SLIDER FOR AGENT A TO ENABLE TO SET OPERATION ENABLED STATE
HAS RESTART OPERATION BEEN PERFORMED?
S46
NO
YES
IS CHANGE PATTERN OF REWARD FOR AGENT B PATTERN p3?
S47
NO
YES
S48
ALERT MESSAGE text =
"LEARNING OF AGENT B HAS FAILED. RESET WEIGHT PARAMETER"
ISSUE (DISPLAY) ALERT USING ALERT MESSAGE text
S49
INITIALIZE ACTIVATION OF ALL SLIDERS TO DISABLE TO SET OPERATION DISABLED STATE
S50
SET ACTIVATION OF SLIDER FOR AGENT B TO ENABLE TO SET OPERATION ENABLED STATE
HAS RESTART OPERATION BEEN PERFORMED?
S51
NO
YES
1

FIG.15

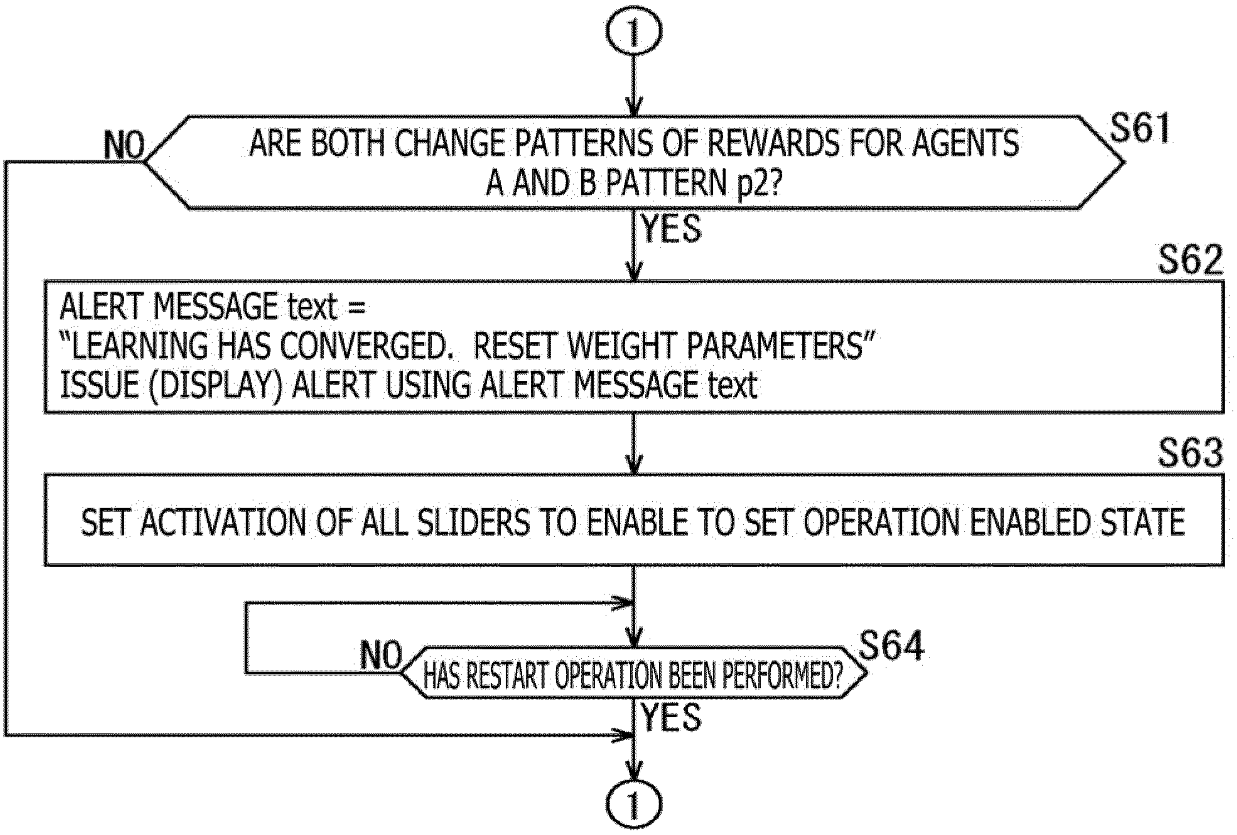
1
ARE BOTH CHANGE PATTERNS OF REWARDS FOR AGENTS A AND B PATTERN p2?
S61
NO
YES
S62
ALERT MESSAGE text =
"LEARNING HAS CONVERGED. RESET WEIGHT PARAMETERS"
ISSUE (DISPLAY) ALERT USING ALERT MESSAGE text
S63
SET ACTIVATION OF ALL SLIDERS TO ENABLE TO SET OPERATION ENABLED STATE
S64
NO
HAS RESTART OPERATION BEEN PERFORMED?
YES
1

FIG.16

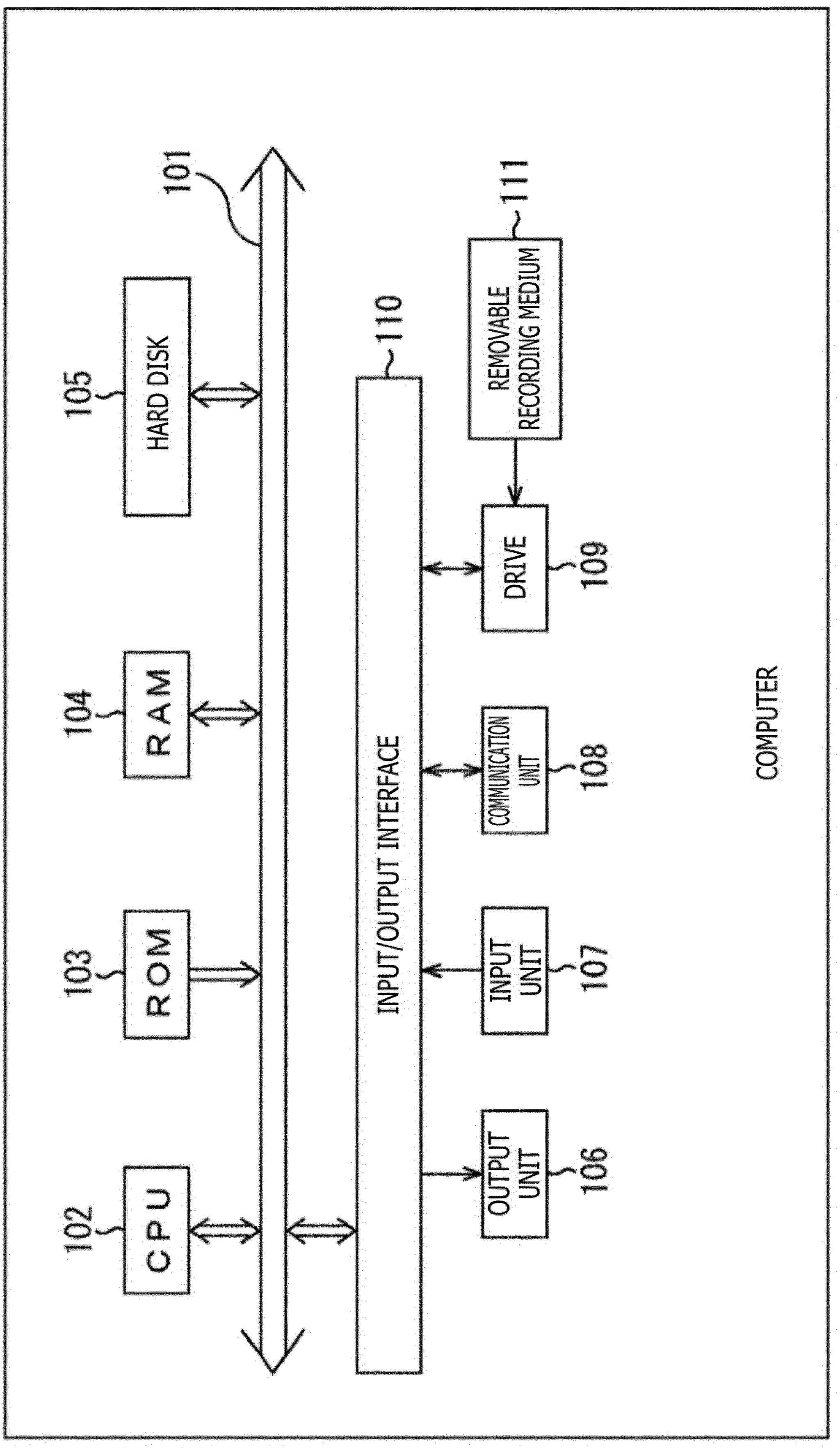
101
102
CPU
103
ROM
104
RAM
105
HARD DISK
110
INPUT/OUTPUT INTERFACE
111
REMOVABLE RECORDING MEDIUM
DRIVE
109
COMMUNICATION UNIT
108
INPUT UNIT
107
OUTPUT UNIT
106
COMPUTER

## INTERNATIONAL SEARCH REPORT

International application No.
PCT/JP2017/043163

A. CLASSIFICATION OF SUBJECT MATTER
G06N99/00(2010.01)i
According to International Patent Classification (IPC) or to both national classification and IPC

B. FIELDS SEARCHED
Minimum documentation searched (classification system followed by classification symbols)
G06N99/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | 伊藤昭, 外 3 名, 「相手を読む」戦略の獲得-標準ゲームの提案, [2003]年度人工知能学会全国大会(第 17 回)論文集, 2003, 3D1-05, in particular, p. 3, left column, line 1 to p. 4, left column, line 22 (ITO, Akira et al. The acquisition of the strategy to “read others” - A proposal of a standard problem. The 17th Annual Conference of the Japanese Society for Artificial Intelligence.) | 1, 7<br>2-3<br>4-6 |
| Y | 江口徹, 外 4 名, 報酬自動調整機能を備えた強化学習法によるプラント制御技術, 電気学会論文誌 01 July 2009, vol. 129, no. 7, pp. 1253-1263, in particular, p. 1256, right column, line 12 to p. 1257, left column, line 10 (EGUCHI, Toru et al. A Plant Control Technology Using Reinforcement Learning Method with Automatic Reward Adjustment. IEEJ Transactions on Electronics, Information and Systems.) | 2-3 |

☒ Further documents are listed in the continuation of Box C. ☐ See patent family annex.

* Special categories of cited documents:
“A” document defining the general state of the art which is not considered to be of particular relevance
“E” earlier application or patent but published on or after the international filing date
“L” document which may throw doubts on priority claim(s) or which is cited to establish the publication date of another citation or other special reason (as specified)
“O” document referring to an oral disclosure, use, exhibition or other means
“P” document published prior to the international filing date but later than the priority date claimed
“T” later document published after the international filing date or priority date and not in conflict with the application but cited to understand the principle or theory underlying the invention
“X” document of particular relevance; the claimed invention cannot be considered novel or cannot be considered to involve an inventive step when the document is taken alone
“Y” document of particular relevance; the claimed invention cannot be considered to involve an inventive step when the document is combined with one or more other such documents, such combination being obvious to a person skilled in the art
“&” document member of the same patent family

| Date of the actual completion of the international search | Date of mailing of the international search report |
|---|---|
| | |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2017/043163

C (Continuation). DOCUMENTS CONSIDERED TO BE RELEVANT

| Category* | Citation of document, with indication, where appropriate, of the relevant passages | Relevant to claim No. |
|---|---|---|
| A | JP 2011-22902 A (RITSUMEIKAN UNIVERSITY) 03 February 2011, entire text, all drawings (Family: none) | 1-7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **MNIH ; VOLODYMYR et al.** Human-level control through deep reinforcement learning. *Nature,* 2015, vol. 518 (7540), 529-533